(19) Europäisches Patentamt
European Patent Office
Office européen des brevets

(11) **EP 2 443 681 B1**

(12) **EUROPÄISCHE PATENTSCHRIFT**

(45) Veröffentlichungstag und Bekanntmachung des Hinweises auf die Patenterteilung:
**13.11.2019 Patentblatt 2019/46**

(21) Anmeldenummer: **10724858.5**

(22) Anmeldetag: **16.06.2010**

(51) Int Cl.:
**H01L 51/52** *(2006.01)*

(86) Internationale Anmeldenummer:
**PCT/EP2010/058481**

(87) Internationale Veröffentlichungsnummer:
**WO 2010/146091 (23.12.2010 Gazette 2010/51)**

(54) **STRAHLUNGSEMITTIERENDE VORRICHTUNG**

LIGHT EMITTING DEVICE

DISPOSITIF EMETTANT DE LA LUMIÈRE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **16.06.2009 DE 102009025123**

(43) Veröffentlichungstag der Anmeldung:
**25.04.2012 Patentblatt 2012/17**

(73) Patentinhaber:
• **OSRAM OLED GMBH**
**93049 Regensburg (DE)**
• **Covestro Deutschland AG**
**51373 Leverkusen (DE)**

(72) Erfinder:
• **KRUMMACHER, Benjamin, Claus**
**93051 Regensburg (DE)**
• **PUDLEINER, Heinz**
**47800 Krefeld (DE)**

• **MEYER, Klaus**
**41539 Dormagen (DE)**

(74) Vertreter: **Epping - Hermann - Fischer Patentanwaltsgesellschaft mbH**
**Postfach 20 07 34**
**80007 München (DE)**

(56) Entgegenhaltungen:
**WO-A1-02/37580        WO-A1-2009/081750**
**WO-A2-2006/134536      DE-A1-102006 059 129**
**JP-A- 2003 109 747     JP-A- 2004 212 716**
**JP-A- 2006 030 872     US-A1- 2003 124 752**
**US-A1- 2005 057 176    US-A1- 2009 015 142**

• **GREINER H: "Light extraction from organic light emitting diode substrates: Simulation and experiment" JAPANESE JOURNAL OF APPLIED PHYSICS, JAPAN SOCIETY OF APPLIED PHYSICS, JP LNKD- DOI:10.1143/JJAP.46.4125, Bd. 46, Nr. 7A, 1. Juli 2007 (2007-07-01), Seiten 4125-4137, XP001517975 ISSN: 0021-4922**

**Beschreibung**

Die Erfindung betrifft eine strahlungsemittierende Vorrichtung mit einer Strahlungsauskopplungsschicht, die eine regelmäßige Mikrostrukturierung aufweist.

Strahlungsemittierende Vorrichtungen, wie beispielsweise OLEDs (Organic Light Emitting Diodes), weisen üblicherweise ein Lambertsches Abstrahlungsprofil auf. Für Beleuchtungszwecke ist jedoch meist ein davon abweichendes, gerichtetes Abstrahlungsprofil geeigneter.

Die Druckschrift WO 02/37580 A1 betrifft die Helligkeitssteigerung von Anzeigevorrichtungen.

In der Druckschrift JP 2003-109747 A ist ein Display mit einer organischen Leuchtdiode angegeben.

Ein Display mit einer Linsenfolie ist in der Druckschrift JP 2006-030872 A offenbart.

Die Beschreibung eines Displays mit einer einstellbaren Farbe findet sich in der Druckschrift US 2005/0057176 A1.

Die Lichtextraktion aus organischen Leuchtdioden heraus betrifft der Artikel Horst Greiner in Japanese Journal of Applied Physics, Vol. 46, No. 7A aus dem Jahr 2007, Seiten 4125 bis 4137.

Eine oberflächenemittierende Lichtquelle ist in der Druckschrift WO 2009/081750 A1 wiedergegeben.

Die Druckschrift WO 2006/134536 A2 beschreibt eine Beleuchtungseinrichtung mit einer organischen elektrolumineszierenden Schicht, auf der in Abstrahlrichtung ein Substrat mit einer Licht kollimierenden Struktur und einer daneben angeordneten Licht streuenden Struktur angeordnet ist. Die Licht kollimierende Struktur kann durch ein Linsenarray gebildet werden.

Eine Aufgabe der Erfindung ist es, eine strahlungsemittierende Vorrichtung anzugeben, deren Abstrahlungsprofil von dem eines Lambertschen Strahlers abweicht.

Diese Aufgabe wird durch die strahlungsemittierende Vorrichtung gemäß dem Hauptanspruch gelöst. Vorteilhafte Ausgestaltungen und Weiterbildungen sind Gegenstand von Unteransprüchen.

Eine erfindungsgemäße strahlungsemittierende Vorrichtung umfasst eine zur Strahlungserzeugung ausgebildete aktive Schicht, die im Betrieb eine Primärstrahlung emittiert, und eine auf der aktiven Schicht angeordnete Strahlungsauskopplungsschicht. Die Strahlungsauskopplungsschicht ist hierbei im Strahlengang der von der aktiven Schicht emittierten Primärstrahlung angeordnet. Die Strahlungsauskopplungsschicht besitzt eine der aktiven Schicht zugewandte Seite und eine der aktiven Schicht abgewandten Seite, wobei die abgewandte Seite eine Mikrostrukturierung mit regelmäßig angeordneten geometrischen Strukturelementen aufweist. Unter regelmäßig angeordnet wird hierbei verstanden, dass entweder das Strukturelement selbst ein oder mehrere Symmetrieelemente (insbesondere Symmetrieebenen) aufweist oder dass eine durch eine Vielzahl von Strukturelementen gebildete Struktur Symmetrieelemente (beispielsweise Parallelverschiebungen) aufweist. Die Strahlungsauskopplungsschicht ist ferner dadurch charakterisiert, dass sie zumindest in Teilbereichen Regionen enthält, die eine Streuung der Strahlung (insbesondere der Primärstrahlung) bewirken.

Die mittels der aktiven Schicht erzeugte Strahlung wird mittels der Streu-Regionen gestreut, wodurch gegenüber einer Vorrichtung ohne entsprechende Streu-Regionen eine homogenere Verteilung der Strahlungsleistung erzielt werden kann. Zudem kann durch Streuereignisse an oder in der Strahlungsauskopplungsschicht der Strahlverlauf der Strahlung gestört werden. Dies führt zu einer Erhöhung der im Betrieb des Bauelements ausgekoppelten Strahlungsleistung. Insbesondere kann ein unerwünschter Strahlenverlauf in der Vorrichtung (der insbesondere in Form von Totalreflexion in der Vorrichtung auftreten kann) gestört werden und die aus der Vorrichtung ausgekoppelte Strahlungsleistung daher erhöht werden.

Durch die Mikrostrukturierung der der aktiven Schicht abgewandten Seite der Strahlungsauskopplungsschicht mit regelmäßig angeordneten geometrischen Strukturelementen erfolgt an der Grenzfläche zum Umgebungsmedium eine Brechung der auf die Grenzfläche auftreffenden Strahlung (insbesondere eine Lichtbrechung). Aufgrund der Tatsache, dass eine Totalreflexion der austretenden Strahlung an der Grenzfläche vermindert oder vollständig unterbunden werden kann, besitzt die ausgekoppelte Strahlung zum einen einen verbesserten Wirkungsgrad und zeigt zum anderen keine Lambertsche Abstrahlcharakteristik mehr, wobei insbesondere bei einem Betrachtungswinkel von +45 bis -45 Grad (bezogen auf die Flächennormale der der aktiven Schicht zugewandten Seite bzw. Fläche der Strahlungsauskopplungsschicht) eine erhöhte Intensität aufweist. Durch geeignete Wahl der geometrischen Strukturelemente kann die Intensität für einen vorgegebenen Betrachtungswinkel oder Winkelbereich optimiert werden. Insbesondere um Intensitätsverluste zu vermeiden, sollte die Strahlungsauskopplungsschicht sowie sämtliche Flächen der der aktiven Schicht zugewandten und der aktiven Schicht abgewandten Seite vollständig transparent sein.

Aufgrund der Tatsache, dass die der aktiven Schicht abgewandten Seite der Strahlungsauskopplungsschicht geometrische Strukturelemente aufweist, existieren nur wenige oder gar keine Oberflächenbereiche auf dieser Seite, die zur der aktiven Schicht zugewandten Seite der Strahlungsauskopplungsschicht parallele Flächen aufweisen. Hierdurch erfolgt an der Grenzfläche von Strahlungsauskopplungsschicht und Umgebungsmedium eine verstärkte Brechung der ausgekoppelten Strahlung in Richtung des Normalenvektors der der aktiven Schicht zugewandten Fläche der Strahlungsauskopplungsschicht (bzw. von Betrachterwinkeln, die insbesondere um bis zu 30 oder bis zu 45 Grad hiervon abweichen). Im Vergleich zu Strahlungsauskopplungsschichten mit unregelmäßigen Oberflächenstrukturen haben die erfindungsgemäßen Strahlungsauskopplungsschichten den Vorteil, dass die Oberfläche der strahlungsemittierenden Vorrichtungen etwas weniger matt ist. Die Verwendung einer Strahlungsauskopplungsschicht mit einer Kombination von die Strahlung (insbesondere die Primärstrahlung) streuenden Regionen und geometrischen Strukturelementen auf der der aktiven Schicht abgewandten Seite der Strahlungsauskopplungsschicht hat ferner den Vorteil, dass die Abhängigkeit der Emissionsfarbe vom Beobachtungswinkel vermindert wird.

Bei Bauelementen ohne die erfindungsgemäße Strahlungsauskopplungsschicht kann durch Totalreflexion an der der aktiven Schicht abgewandten Oberflächenseite des Substrats Strahlung in das Substrat zurückreflektiert werden und beispielsweise an einer nicht erwünschten Fläche, z.B. einer Seitenfläche austreten. Außerdem kann reflektierte Strahlung im Bauelement absorbiert werden. Durch beide Effekte wird die Effizienz des Bauteils verringert, da weniger Strahlungsleistung ausgekoppelt wird.

In der erfindungsgemäßen Vorrichtung wird an der Grenzfläche zwischen Umgebungsmedium und Strahlungsauskopplungsschicht in das Bauteil rückreflektierte Strahlung an den in der Strahlungsauskopplungsschicht enthaltenen Streupartikeln gestreut, so dass die Strahlung so gelenkt wird, dass ein erhöhter Anteil der Strahlung über die Strahlungsauskopplungsschicht ausgekoppelt werden kann. Hierdurch wird die Auskopplungseffizienz der strahlungsemittierenden Vorrichtung erhöht.

Die Strahlungsauskopplungsschicht kann auch nachträglich auf der strahlungsemittierenden Vorrichtung befestigt werden, so dass es möglich ist nur Teilbereiche einer strahlungsemittierenden Vorrichtung oder nur ausgewählte Vorrichtungen mit der Strahlungsauskopplungsschicht zu versehen. Die Strahlungsauskopplungsschicht kann also bedarfsgemäß vorgesehen werden.

In einer Ausführungsform ist die strahlungsemittierende Vorrichtung eine organische Leuchtdiode, die zur Emission elektromagnetischer Strahlung ausgebildete aktive Schicht aufweist, und bei der die aktive Schicht ein organisches Material aufweist.

Bevorzugt ist die erfindungsgemäße strahlungsemittierende Vorrichtung als organisches strahlungsemittierendes Bauelement, insbesondere als organische lichtemittierende Diode (OLED), ausgebildet. Die aktive Schicht ist hierbei üblicherweise mittels einer organischen Schicht gebildet, die ein organisches (halb)leitendes Material enthält oder daraus besteht und zur Emission elektromagnetischer Strahlung ausgebildet ist. Die organische Schicht enthält dabei z.B. ein oder mehrere (halb)leitende Polymere und/oder umfasst mindestens eine Schicht mit einem (halb)leitenden Molekül, insbesondere einem niedermolekularen Molekül ("small molecule").

Eine die erfindungsgemäße Anordnung aufweisende (oder eine vorgefertigte) OLED weist insbesondere Elektroden für die elektrische Kontaktierung und gegebenenfalls auch eine die organische Schicht oder die organischen Schichten schützende Verkapselung auf, welche die organische(n) Schicht(en) insbesondere vor Sauerstoff und Feuchtigkeit schützen kann. Weiterhin ist als organische Schicht zumindest eine Emitterschicht vorhanden. Weiterhin können z.B. auch Lochinjektionsschichten, Lochtransportschichten, Elektronentransportschichten, Barriereschichten und/oder Blockierschichten enthalten sein.

In einer Ausführungsform umfasst die strahlungsemittierende Vorrichtung ein Substrat, auf dem die aktive Schicht (insbesondere die organische Schicht bzw. die organischen Schichten der OLED), angeordnet ist. Auf dem Substrat kann bei der Herstellung der Vorrichtung beispielsweise die aktive Schicht, insbesondere der Schichtenstapel aus lichtemittierender Schicht, Elektroden und weiteren Schichten der OLED, aufgebracht werden. Bei einer Ausführung der strahlungsemittierenden Vorrichtung als Bottomemitter (bei der ein transparentes Substrat verwendet wird) wird die Strahlungsauskopplungsschicht üblicherweise auf der von der aktiven Schicht abgewandten Seite des Substrats angeordnet. Durch die hohe mechanische Stabilität des Substrats kann die Strahlungsauskopplungsschicht hierbei durch die dauerhafte Befestigung der Lichtgauskopplungsschicht auf dem Substrat mechanisch stabilisiert werden. Das Substrat kann allerdings auch flexibel ausgebildet sein; beispielsweise kann es in einer Kunststofffolie bestehen.

Das Substrat kann vollflächig oder zumindest im Wesentlichen vollflächig mit der erfindungsgemäßen Strahlungsauskopplungsschicht versehen sein. Üblicherweise ist zumindest der Teil des Substrats mit der Strahlungsauskopplungsschicht versehen, der im Strahlengang (noch nicht reflektierter oder gestreuter) von der aktiven Schicht emittierter Strahlung liegt. Insbesondere überdeckt die Strahlungsauskopplungsschicht zumindest den Bereich des Substrats, der in Fläche, Flächeninhalt und (horizontaler) Position dem der aktiven Schicht entspricht.

In einer Ausführungsform umfassen die Regionen, die eine Brechung oder eine Streuung der Primärstrahlung bewirken, Streupartikel, insbesondere strahlungsdurchlässige Streupartikel. Die Streupartikel können den für die Strahlungsauskopplungsschicht verwendete Matrix problemlos zugesetzt werden; es können sogar wohldefinierte lokale Streuzonen ausgebildet werden. Als Streupartikel sind sowohl anorganische als auch organische Partikel geeignet; insbesondere sind Polymerpartikel als Streupartikel zu nennen.

Durch die Streupartikel wird der Strahlverlauf von Strahlung (z.B. der Lichtstrahlen) aus der ursprünglichen Richtung (das heißt der Richtung vor dem Streuereignis) abgelenkt.

In einer weiteren Ausführungsform umfassen die Regionen, die eine Brechung oder eine Streuung der Primärstrahlung bewirken Hohlräume. Durch diese Hohlräume können in der Matrix der Strahlungsauskopplungsschicht Brechungsindex-Inhomogenitäten ausgebildet werden. Diese Hohlräume können insbesondere gasgefüllt, z.B. luftgefüllt, sein. Hierdurch können besonders hohe Brechungsindexunterschiede ausgebildet werden. Hierbei erfolgt eine Streuung durch Brechung hauptsächlich aufgrund des vergleichsweise hohen Brechungsindexunterschieds zwischen Innenraum und Wandung des Hohlraums.

Die genannten Hohlräume können z.B. auch in Form von Hohlpartikeln vorliegen. Diese Partikel können insbesondere aus strahlungsdurchlässigen polymeren Materialien bestehen, die einen polymerfreien Innenraum umschließen. Im Regelfall unterscheidet sich der Brechungsindex der Polymere der Hohlpartikel von dem Brechungsindex der Matrix, in der die Hohlpartikel vorliegen, deutlich weniger wie sich der Brechungsindex des im Hohlraum enthaltenen Gases von dem der beiden Polymere unterscheidet. Dadurch wird auch in diesen Partikeln die Brechung der auf dem Hohlpartikel auftreffenden Strahlung im Wesentlichen durch den in Partikel enthaltenen Hohlraum erfolgen. Transparente Schichten mit derartigen Hohlräumen bzw. Hohlpartikeln sind beispielsweise in der US 2006/0290272 beschrieben. In einer weiteren Ausführungsform können die Streupartikel einen Kern-Schale-Aufbau aufweisen. Üblicherweise sind diese Partikel als Vollpartikel ausgebildet. Durch die Verwendung derartiger Partikel kann für das Kernmaterial fast jegliches Material eingesetzt werden, da die Schale aus einem Material ausgebildet sein kann, das sich sowohl mit der Matrix der Strahlungsauskopplungsschicht als auch mit dem Kern verträgt und somit das Problem eines mit der Matrix nicht verträglichen Kernmaterials behoben werden kann. Durch derartige Kern-Schale-Partikel kann die mechanische Stabilität der Strahlungsauskopplungsschicht dann erhöht werden.

In einer Ausführungsform weisen die lichtstreuenden Regionen, insbesondere die lichtstreuenden Partikel, Hohlpartikel und Gaseinschlüsse einen mittleren Durchmesser von 0,5 bis 100 $\mu$m, insbesondere von 2 bis 20 $\mu$m auf. In Einzelfällen können aber auch mittlere Durchmesser von bis zu 120 $\mu$m vorliegen. Ferner sind auch mittlere Durchmesser von 2 $\mu$m bis 30 $\mu$m und auch von 2 $\mu$m bis 50 $\mu$m gut geeignet. Unter mittlerem Durchmesser wird hierbei der mittels Lichtstreuung ermittelte Durchmesser verstanden. Bevorzugt haben zumindest 90 Prozent, besonders bevorzugt mindestens 95 Prozent der lichtstreuenden Regionen einen Durchmesser von mehr als 1 $\mu$m und kleiner 120 $\mu$m. Derartige Abmessungen verleihen der Strahlungsauskopplungsschicht besonders gute diffusive Eigenschaften, insbesondere für die Streuung von sichtbarem Licht. Für eine OLED haben sich hierbei Durchmesser zwischen 2 $\mu$m und 30 $\mu$m als besonders geeignet erwiesen.

In einer weiteren Ausführungsform besitzen die geometrischen Strukturelemente der Strahlungsauskopplungsschicht eine im Wesentlichen gleiche geometrische Form. Eine Mikrostrukturierung mit derartigen Strukturelementen kann dann besonders leicht in der Strahlungsauskopplungsschicht ausgebildet werden. Es ist allerdings auch möglich, dass sich verschiedene geometrische Strukturelemente abwechseln (z.B. Strukturelemente nach Art eines Kugelsegments und Strukturelemente nach Art eines Segments eines Rotationsellipsoids).

In einer weiteren Ausführungsform haben die geometrischen Strukturelemente der Strahlungsauskopplungsschicht jeweils eine in etwa gleiche Dimension, das heißt, dass das Volumen der Strukturelemente in etwa gleich ist. Als Volumen des Strukturelements wird hierbei der Teil der Strahlungsauskopplungsschicht angesehen, der von der zu der mikrostrukturierten Seite gegenüberliegenden Fläche der Strahlungsauskopplungsschicht parallelen Ebene und dem auf der Strahlungsauskopplungsschicht ausgebildeten geometrischen Strukturelement eingeschlossen wird. Auf einen derart charakterisierten in der Mikrostrukturierung enthaltenen Körper beziehen sich auch alle nachfolgend angegebenen geometrischen Angaben. Besitzen die geometrischen Strukturelemente eine im Wesentlichen gleiche Dimension, so ist auch hierdurch eine einfache Herstellung der Mikrostrukturierung auf der Strahlungsauskopplungsschicht möglich.

Alternativ können allerdings auch geometrische Strukturelemente mit unterschiedlichen Dimensionen in der Strahlungsauskopplungsschicht vorhanden sein. Beispielsweise können sich zwei Strukturelemente mit unterschiedlichen Volumina abwechseln (wobei z.B. das Volumen des größeren Strukturelements das des kleineren Strukturelements beispielsweise um mindestens 50 Prozent übersteigt, z.B. jeweils bei Strukturelementen in Form eines Segments eines Rotationsellipsoids; derartige Strukturelemente können sich beispielsweise regelmäßig abwechseln - so kann etwa eine Struktur ausgebildet werden, bei der jedes dritte Strukturelement ein größeres Volumen besitzt).

Durch die Wahl geometrischer Strukturelemente verschiedener Dimension und/oder geometrischer Form können für bestimmte Anwendungen unerwünschte Effekte vermindert oder sogar unterbunden werden (z.B. die Überlagerung von Lichtstrahlen nach Art von Beugungsmustern oder Interferenzeffekte z.B. aufgrund periodischer Strukturen, die durch bestimmte Strukturelemente hervorgerufen werden können und Moire-Effekte).

In einer Ausführungsform werden die geometrischen Strukturelemente ausgewählt aus Strukturelementen nach Art eines Kugelsegments, nach Art eines Segments eines Rotationsellipsoids, nach Art einer Pyramide und nach Art eines Kegels bzw. in Form eines Kugelsegments, in Form eines Segments eines Rotationsellipsoids, in Form einer Pyramide und in Form eines Kegels sowie aus Mischungen dieser Strukturelemente. Als Mischungen der Strukturelemente sind hierbei nicht nur die vorstehend genannten Mischungen von verschiedenen Strukturelementen, die zueinander unterschiedliche geometrische Formen aufweisen zu verstehen, sondern auch Strukturelemente, bei denen (ausgehend von einer zu der mikrostrukturierten Seite gegenüberliegenden Seite parallelen Basisfläche) z.B. eine Pyramide in ein Kugelsegment übergeht oder bei dem ein Segment eines Rotationsellipsoids in einen Kegel übergeht. Denkbar ist z.B. auch, dass das geometrische Strukturelement die Basis einer Pyramide aufweist, im mittleren Bereich die Oberfläche eines Rotationsellipsoids besitzt und an der Spitze eine Kegelspitze aufweist. Unter Strukturelementen "nach Art eines ..." sind also insbesondere Strukturelemente zu verstehen, bei denen nach flüchtiger Betrachtung der Eindruck eines Kugelsegments, eines Rotationsellipsoid-Segments, einer Pyramide oder eines Kegels vorherrscht, bei dem aber auch anders geartete Flächen, insbesondere andere der vorstehend genannten geometrischen Körper enthalten sein können.

Die vorstehend genannten geometrischen Körper können dabei nicht nur hochsymmetrische Basisflächen aufweisen. Beispielsweise kann der Kegel oder das Rotationsellipsoid-Segment eine kreisförmige oder eine ellipsoide Basisfläche besitzen. Die Pyramide kann insbesondre eine reguläre Pyramide sein. Weiterhin können die Pyramiden auch rechteckige oder trapezförmige Basisflächen haben.

In einer Ausführungsform weisen die geometrischen Strukturelemente eine oder mehrere Symmetrieebenen (d.h. Spiegelebenen) auf. Hierbei sind die Symmetrieebenen gemeint, die auf der durch die der mikrostrukturierten Seite gegenüberliegenden Seite der Strahlungsauskopplungsschicht gebildeten Ebene (und den hierzu parallelen Ebenen die die Basisflächen der Symmetrieelemente bilden) senkrecht stehen. Bevorzugt weisen die geometrischen Strukturelemente mindestens zwei, üblicherweise sogar mindestens drei oder sogar mindestens vier derartige Symmetrieebenen auf. Eine Mikrostrukturierung mit derartigen Strukturelementen kann besonders einfach hergestellt werden.

Gemäß der Erfindung besitzt das geometrische Strukturelement gekrümmte Außenflächen (das heißt Flächen, die Grenzflächen mit dem umgebenden Medium bilden).

In einer weiteren Ausführungsform, nicht gemäß der Erfindung, besitzt das geometrische Strukturelement eine Form, die nur angenähert der eines Kugelsegments entspricht (eine derartige Form ist z.B. die Form optischer Linsen). Derartige Strukturelemente besitzen im Bereich der "optischen Achse" Flächensegmente, die nahezu parallel zur Grundfläche des Körpers verlaufen und in denen daher das Lichtbrechungsverhalten dem einer ebenen Fläche ähnelt. Die Effizienz der erfindungsgemäßen strahlungsemittierenden Vorrichtung kann weiter optimiert werden, wenn die geometrischen Strukturelemente im Bereich der "optischen Achse" des Strukturelements eine stärkere Krümmung besitzen oder eine Art Kegelspitze aufweisen.

Gemäß der Erfindung haben die geometrischen Strukturelemente folgende Form: Alle oder zumindest die Mehrheit der auf der Außenfläche des Strukturelements vom Maximum des Strukturelements (das insbesondere auf der "optischen Achse" des Strukturelements liegt) verlaufenden ebenen Kurven besitzen im Bereich des Maximums des Strukturelements eine stärkere Krümmung als im Bereich der Basis des Strukturelements. Hierbei sind als ebene Kurven die Kurven gemeint, die auf der Außenfläche des geometrischen Strukturelements verlaufen wie vom Pol zum Äquator verlaufende Längengrade eines Globus. Gemäß der Erfindung weisen alle diese ebenen Kurven im oberen Drittel der Kurve nur Krümmungen auf, die größer sind als die Krümmungen im unteren Drittel. Die Krümmungen im mittleren Drittel liegen im Regelfall zwischen diesen Krümmungen.

Wie vorstehend geschildert, haben derartige geometrische Strukturelemente den Vorteil, dass Bereiche mit für bestimmte Anwendungszwecke eher ungünstigen Lichtbrechungsverhalten (da sie größere Bereiche aufweisen, die im Wesentlichen parallel zur Basisfläche des geometrischen Körpers verlaufen) minimiert werden. Außerdem lassen sich diese Strukturelemente relativ einfach in eine Polymerschmelze abprägen. Aufgrund der abgerundeten Spitze sind sie unempfindlich gegenüber Abrieb durch weitere aufgelegte Folien. Dagegen sind Strahlungsauskopplungsschichten mit unregelmäßigen Oberflächenstrukturen oder mit Strukturelementen nach Art eines Prismas gegen Abrieb empfindlich.

In einer Ausführungsform besitzen die geometrischen Strukturelemente der mikrostrukturierten Fläche der Strahlungsauskopplungsschicht eine Grundfläche, die ein Polygon ist. Unter einem Polygon wird hierbei das mathematisch korrekt beschriebene nicht überschlagene, konvexe, einfache, planare Polygon verstanden. Insbesondere sind hierbei regelmäßige Vielecke zu nennen (bei denen alle Kanten der Grundfläche gleich lang sind). Durch die Verwendung von geometrischen Strukturelementen mit derartigen Basisflächen kann die der aktiven Schicht abgewandte Seite der Strahlungsauskopplungsschicht vollständig (d.h. vollflächig) mit den geometrischen Strukturelementen versehen sein; es bleiben also anders als bei der Anordnung von Kugelsegmenten oder Kegeln keine ebenen Flächen zwischen den einzelnen Strukturelementen bestehen. Dies hat den bereits vorstehend beschriebenen Vorteil, dass für verschiedene Anwendungen unerwünschte Brechungen der Strahlen an der Grenzfläche zwischen Strahlungsauskopplungsschicht und Umgebungsmedium vermieden werden können und auch die eher unerwünschte Totalreflexion an derartigen Flächen nicht stattfinden kann. Eine vollständige Flächenausfüllung mit geometrischen Strukturelementen kann beispielsweise erfolgen, wenn die Basisflächen der Strukturelemente jeweils lauter gleichartige Dreiecke, Vierecke oder Sechsecke sind, wobei hierbei insbesondere die Polygone mit gleichen Seitenlängen und gleichen Innenwinkeln zu nennen sind. Denkbar ist aber auch die Verwendung unterschiedlicher Polygone (z.B. Quadrate neben Rauten oder Achtecke neben Quadraten).

In einer weiteren Ausführungsform ist die Mikrostrukturierung der Strahlungsauskopplungsschicht derart ausgebildet, dass sie mittels einer Metallwalze in eine Oberfläche der (noch nicht strukturierten) Strahlungsauskopplungsschicht einprägbar ist. Es ist dann möglich, die Mikrostrukturierungen besonders leicht und unproblematisch in die (noch nicht strukturierte) Strahlungsauskopplungsschicht einzuprägen. Die Negative der Strukturelemente können dabei beispielsweise mittels Diamant in die Metallwalze eingeschnitten werden. Das Einprägen in die (nicht strukturierte) Strahlungsauskopplungsschicht kann dann erfolgen, in dem das für die Strahlungsauskopplungsschicht verwendete polymere Material nach dem Einprägen der Struktur so rasch abgekühlt wird, dass die Struktur auf der Oberfläche fixiert wird. Alternativ kann das Fixieren der Struktur auch mittels fotochemischer Prozesse erfolgen, die ein Verfließen der eingeprägten Struktur verhindern. Verfahren und Vorrichtungen zu einer derartigen Einprägung der Mikrostrukturierung in die Oberfläche der Strahlungsauskopplungsschicht sind in der US 2007/0126148 und der US 2007/0126145 beschrieben.

Gemäß der Erfindung ist die Mikrostrukturierung der Strahlungsauskopplungsschicht derart ausgebildet, dass die Maxima zueinander benachbarter geometrischer Strukturelemente einen Abstand von 30 bis 500 $\mu$m, insbesondere von 100 bis 250 $\mu$m, beispielsweise von 100 bis 170 $\mu$m, besitzen. Besitzen die Strukturelemente mehrere Maxima (was allerdings nicht der Regelfall ist) so tritt für die vorstehende Definition an die Stelle des Maximums der Schwerpunkt des Strukturelements. Unter benachbarten Strukturelementen werden hierbei nur die jeweils direkten Nachbarn verstanden, insbesondere Strukturelemente, die gemeinsame Kanten haben oder deren Basisflächen sich berühren. Anders ausgedrückt ist bei Mikrostrukturierungen mit genau einem Typ von geometrischen Strukturelementen und mit vollkommen symmetrischer Anordnung der Strukturelemente auf der Strahlungsauskopplungsseite der Strahlungsauskopplungsschicht der Abstand der Maxima die Wiederholungseinheit.

Eine Strahlungsauskopplungsschicht mit einer derart ausgebildeten Mikrostrukturierung ist besonders einfach - z.B. mittels einer Metallwalze - in die (noch nicht strukturierte) Strahlungsauskopplungsschicht einprägbar. Besonders präzise geometrische Strukturelemente werden erhalten, wenn die Maxima 20 $\mu$m oder mehr voneinander entfernt sind.

In einer weiteren Ausführungsform weisen der Durchmesser der Basis des Strukturelements und de Höhe des Strukturelements (gemessen zwischen Basisfläche und Maximum) ein Verhältnis Basisdurchmesser : Höhe von etwa 1 : 1 bis 3 : 1, insbesondere von 1,5 : 1 bis 2,5 : 1 auf. Alternativ oder zusätzlich sind die geometrischen Strukturelemente dann so ausgebildet, dass im Bereich des Sockels des Strukturelements das Strukturelement mit der Basisfläche einen Winkel von etwa 50 bis 70 Grad, insbesondere 55 bis 65 Grad einschließt. Präziser ausgedrückt weist die Strahlungsauskopplungsseite des Strukturelements an der mit der Basisfläche gebildeten Kante eine (in Richtung des Maximus ausgerichtete) Tangente auf, die mit der Basisfläche den vorstehend genannten Winkel einschließt.

Strukturelemente, die dieser Ausführungsform entsprechen, sind nicht nur einfach (z.B. mittels des vorstehend beschriebenen Prägeverfahrens) herstellbar; sie besitzen auch eine Struktur, die eine besonders effiziente Strahlungsauskopplung gewährleistet. Strahlen die in einem Beobachtungswinkel von etwa -40 bis +40 Grad ausgetreten sind(bezogen auf die oben definierte Flächennormale) können dann im Regelfall (sobald sie ausgekoppelt sind) nicht mehr auf die Außenfläche eines benachbarten Strukturelements auftreffen. Die Effizienz der strahlungsemittierenden Vorrichtung kann hierdurch also weiter verbessert werden.

In einer weiteren Ausführungsform weist die Strahlungsauskopplungsschicht der strahlungsemittierenden Vorrichtung neben Regionen, die eine Streuung der Primärstrahlung bewirken, eine transparente Matrix auf. Insbesondere umfasst die Strahlungsauskopplungsschicht eine Matrix, in der Streupartikel, Hohlpartikel oder Hohlräume vorliegen. Die Matrix kann insbesondere aus einem transparenten Polymer, beispielsweise einem Polycarbonat bestehen oder dieses umfassen.

In einer weiteren Ausführungsform ist die Strahlungsauskopplungsschicht an die restliche strahlungsemittierende Vorrichtung brechungsindexangepasst. Der Strahlungsaustritt aus der erfindungsgemäßen Vorrichtung in die Strahlungsauskopplungsschicht wird so erleichtert und die Reflexionsverluste an Grenzfläche(n) zur Strahlungsauskopplungsschicht werden gemindert. Für die Brechungsindexanpassung weicht der Brechungsindex der Strahlungsauskopplungsschicht bzw. für den Fall, dass Streuzonen ausgebildet sind, derjenige des Matrixmaterials bevorzugt um zwanzig Prozent oder weniger, besonders bevorzugt um zehn Prozent oder weniger von dem des angrenzenden Elements der erfindungsgemäßen Vorrichtung (also insbesondere dem Brechungsindex des Substrats) ab. Zur Brechungsindexanpassung an ein Glassubstrat ist beispielsweise ein Polycarbonat für die Strahlungsauskopplungsschicht besonders geeignet.

Alternativ oder ergänzend kann ein Brechungsindexanpassungsmaterial, z.B. ein optisches Gel für die Brechungsindexanpassung, eingesetzt werden, das zwischen der Strahlungsauskopplungsschicht und dem Substrat angeordnet ist. Dieses Material mindert dann den Brechungsindexsprung zwischen Substrat und Strahlungsauskopplungsschicht.

In einer weiteren Ausführungsform ist die Strahlungsauskopplungsschicht auf der darunter liegenden Schicht der erfindungsgemäßen Vorrichtung befestigt, insbesondere stoffschlüssig befestigt. Beispielsweise kann die Strahlungsauskopplungsschicht mittels eines Haftvermittlers auf einem darunter liegenden Substrat der erfindungsgemäßen Vorrichtung befestigt sein, beispielsweise auflaminiert sein. Der Haftvermittler kann hierbei gleichzeitig als Brechungsindexanpassungsmaterial dienen.

In einer weiteren Ausführungsform weist die Strahlungsauskopplungsschicht eine Dicke von mindestens 10 $\mu$m auf. Insbesondere kann die Strahlungsauskopplungsschicht eine Dicke von 25 $\mu$m bis 500 $\mu$m, üblicherweise von 50 $\mu$m bis 300 $\mu$m sein. Häufig weist die Strahlungsauskopplungsschicht eine Dicke größer 70 $\mu$m auf.

Die Strahlungsauskopplungsschicht kann einstückig sein; sie kann allerdings auch aus einem Schichtverbund bestehen. Insbesondere kann die Strahlungsauskopplungsschicht zwei Teilschichten umfassen, wobei in einer Schicht Regionen enthalten sind, die eine Streuung von Strahlung bewirken bzw. diese Schicht vollständig aus solchen Regionen besteht, wobei die Teilschicht insbesondere eine Matrix mit homogenen (also statistisch) darin verteilten Streupartikeln, Hohlpartikeln oder Gaseinschlüssen ist und die andere Teilschicht keine derartigen Bereiche bzw. Partikel oder Gaseinschlüsse aufweist. Im Regelfall wird ein derartiger zweischichtiger Aufbau die Teilschicht ohne lichtbrechende oder lichtstreuende Regionen auf der Strahlungsauskopplungsseite also im Bereich der geometrischen Strukturelemente aufweisen und die Teilschicht mit lichtstreuenden Regionen zwischen dieser Schicht und einem beispielsweise darunter angeordneten Substrat aufweisen.

Eine derartige zwei- oder mehrschichtige Strahlungsauskopplungsschicht kann beispielsweise mittels Coextrusion hergestellt werden, wobei die mindestens zwei Teilschichten durch mindestens zwei Extruder erzeugt werden, wobei die jeweiligen Kunststoffschmelzen in der Düsenlippe zusammengeführt werden.

In einer weiteren Ausführungsform kann die Strahlungsauskopplungsschicht auch aus zwei Teilschichten bestehen, bei denen die Teilschicht auf der Strahlungsauskopplungsseite aus einem Material gebildet ist, das sich besonders gut für ein Prägeverfahren (wie z.B. oben beschrieben) eignet. Die auf der Strahlungsauskopplungsseite vorliegende Teilschicht kann lichtstreuende Regionen enthalten, im Regelfall werden aber keine derartigen Regionen vorliegen. Die darunter liegende, der aktiven Schicht zugewandte Teilschicht wird im Regelfall aus einem Material bestehen, in das besonders gut die lichtbrechenden bzw. lichtstreuenden Regionen eingebracht werden können. Häufig wird dieses Material auch brechungsindexangepasst an die darunter liegende Schicht sein, insbesondere an das Substrat der erfindungsgemäßen Vorrichtung.

Um eine besonders gute Prägbarkeit zu gewährleisten, kann die auf der Strahlungsauskopplungsseite vorliegende Teilschicht aus einem Material mit einer relativen Lösungsviskosität von 1,1 bis 1,4 insbesondere 1,15 bis 1,3, gemessen mittels eines Ubbelohde-Viskosimeters bestehen. Alternativ oder zusätzlich kann das Material einen MVR-Wert (300°C, 1,2 kg) von 1 bis 100 $cm^3/10$ min, bevorzugt 3 bis 80 $cm^3/10$ min, gemessen mittels der ISO-Norm 1133 bestehen. Materialien die diesen Vorgaben genügen sind beispielsweise PMMA (Polymethylmethacrylat) oder bestimmte Polycarbonate (z.B. Makrolon OD 2015, Bayer Material Science AG). Teilschichten aus derartigen Materialien lassen sich häufig mit einer weiteren (nicht geprägten) Teilschicht aus anderen Materialien problemlos coextrudieren. Beispielsweise weisen zwei Teilschichten aus Polycarbonat bzw. aus PMMA eine exzellente Haftung aufeinander auf.

Mögliche weitere transparente Polymere, die hierfür eingesetzt werden können sind folgende thermoplastischen Kunststoffe: amorphe Polyamide, Polycarbonate oder Copolycarbonate auf Basis von Diphenolen, Poly- oder Copolyacrylate und Poly- oder Copolymethacrylate wie beispielhaft und vorzugsweise Polymethylmethacrylat (PMMA), Poly- oder Copolymere mit Styrol wie beispielhaft und vorzugsweise Polystyrol (PS) oder Polystyrolacrylnitril (SAN), thermoplastische Polyurethane, sowie Polyolefine, wie beispielhaft und vorzugsweise Polypropylentypen oder Polyolefine auf der Basis von cyclischen Olefinen (z.B. TOPAS®, Hoechst), Poly- oder Copolykondensate der Terephthalsäure, wie beispielhaft und vorzugsweise Poly- oder Copolyethylenterephthalat (PET oder CoPET), glycol-modifiziertes PET (PETG), glycol-modifiziertes Poly- oder Copolycyclohexandimethy-lenterephthalat (PCTG) oder Poly- oder Copolybutylenterephthalat (PBT oder CoPBT), Poly- oder Copolykondensate der Naphthalindicar-bonsäure, wie beispielhaft und vorzugsweise Polyethylenglykol-naphthalat (PEN), Poly- oder Copolykondensat(e) wenigstens einer Cycloalkyldicarbonsäure, wie beispielhaft und vorzugsweise Polycyclohexandimethanolcyclohexandicarbonsäure (PCCD), Polysulfone (PSU) oder Mischungen aus den vorangehend genannten.

Für Ausführungsformen, bei denen eine Beabstandung der beiden Teilschichten erwünscht ist, kommen insbesondere folgende Materialkombinationen in Frage, bei denen die beiden Teilschichten eine relativ niedrige Haftkraft aufweisen: Polycarbonat/cyclische Olefine, Polycarbonat/amorphe Polyamide, Polycarbonat/ Poly- oder Copolyethylenterephthalat (PET).

In einer weiteren Ausführungsform umfasst die Strahlungsauskopplungsschicht zumindest zwei voneinander beabstandete Teilschichten, wobei zwischen den Teilschichten ein Medium vorliegt, das einen geringeren Brechungsindex aufweist, als die zwei daran angrenzenden Teilschichten. Insbesondere sollte der Brechungsindex des Mediums mindestens fünfzehn Prozent niedriger sein als der Brechungsindex der Teilschicht mit dem niedrigeren Brechungsindex. Die an dieses Trennmedium angrenzenden Grenzflächen der beiden genannten Teilschichten verlaufen dabei im Wesentlichen parallel zueinander; üblicherweise verlaufen diese Grenzflächen auch im Wesentlichen parallel zur der strahlungsemittierenden Funktionsschicht zugewandten Fläche der Strahlungsauskopplungsschicht (die ihrerseits zumeist im Wesentlichen parallel zu der Strahlungsauskopplungsschicht zugewandten Oberfläche des Substrats oder einer anderen Schicht verläuft, auf der die Strahlungsauskopplungsschicht direkt aufgebracht ist). Häufig wird bei einer derartigen Ausgestaltung die Teilschicht, die die geometrischen Strukturelemente enthält, keine Regionen enthalten, in denen eine Lichtbrechung erfolgt; allerdings kann es z.B. aus produktionstechnischen Gründen sinnvoll sein, beide Teilschichten aus demselben Material auszuführen, so dass in beiden Teilschichten derartige Regionen vorliegen können. Weiterhin können die beiden Teilschichten dieser Ausführungsform aus unterschiedlichen oder gleichen Matrixmaterialien bzw. Gemischen von Matrixmaterialien bestehen (die gegebenenfalls die Regionen, in denen eine Lichtbrechung oder Lichtstreuung erfolgt enthalten). Unterschiedliche Materialien können insbesondere dann sinnvoll sein, wenn - wie vorstehend bereits ausgeführt produktionstechnische Aspekte bezüglich der Herstellung der geometrischen Strukturelemente oder das Erfordernis angepasster Brechungsindizes eine Rolle spielen.

Eine derartige Ausführungsform hat den Vorteil, dass Strahlen, die auf die Grenzfläche zwischen der der aktiven Schicht näher gelegenen Teilschicht und dem Beabstandungsmedium in einem flachen Winkel auftreffen durch Totalreflexion in diese Teilschicht (die auch die lichtstreuenden Regionen enthält) zurückreflektiert wird. In die Teilschicht, die die Mikrostrukturierung aufweist, treten daher nur Strahlen ein, die einen relativ großen Winkel mit der Grenzfläche zum Beabstandungsmedium einschließen. Dies führt wiederum dazu, dass der Anteil der Strahlen erhöht werden kann, die in Richtung der Flächennormalen zu dieser Grenzfläche bzw. in Beobachtungswinkeln zwischen -45 und +45 Grad, insbesondere -30 und +30 Grad, abgestrahlt werden. Der Anteil der in Richtung der Flächennormalen bzw. in Beobachtungswinkeln zwischen -45 und +45 Grad, insbesondere -30 und +30 Grad, ausgekoppelten Strahlung kann nochmals erhöht werden, wenn die vorstehend spezifisch genanten geometrischen Strukturelemente als Mikrostrukturierung vorgesehen sind, insbesondere wenn die Strahlungsauskopplungsseite der Strahlungsauskopplungsschicht vollflächig mit Strukturelementen versehen ist und/oder geometrische Strukturelemente Verwendung finden, deren Oberfläche wie vorstehend beschrieben unterschiedliche Krümmungen aufweist.

Das Brechungsmedium zwischen den beabstandeten Teilflächen kann eine Flüssigkeit oder ein Gas sein. Als Gas ist insbesondere Luft, Stickstoff oder ein Edelgas zu nennen. Um möglichst effektiv eine Totalreflexion von Strahlen, die in niedrigen Winkeln auf die Grenzfläche zum Beabstandungsmedium auftreffen einstellen zu können, sollte der Brechungsindex der der aktiven Schicht näher liegenden Teilschicht möglichst hoch sein.

Der Brechungsindex sollte insbesondere größer oder gleich 1,4, bevorzugt größer oder gleich 1,48 und besonders bevorzugt größer oder gleich 1,55 sein. Die Matrix dieser Teilschicht kann beispielsweise aus Polycarbonat bestehen oder dieses enthalten. Auch die die Mikrostrukturierung enthaltende Teilschicht sollte einen möglichst hohen Brechungsindex aufweisen; allerdings sollte diese Schicht auch aus einem Material ausgeführt sein, in das besonders gut eine Mikrostrukturierung einbringbar ist. Diese Schicht kann beispielsweise aus PMMA bestehen oder dieses enthalten.

Strahlung die an der Grenzfläche zwischen der der aktiven Schicht näher liegenden Teilschicht und dem Beabstandungsmedium totalreflektiert wird, kann durch Streuung in den lichtstreuenden Regionen wieder in Richtung dieser Grenzfläche umgelenkt werden, so lange bis keine Totalreflexion mehr stattfindet und die Strahlung in einem relativ steilen Winkel auf die Grenzfläche auftrifft. Hierdurch kann die in Richtung der Flächennormalen bzw. in Beobachtungswinkeln zwischen -45 und +45 Grad, insbesondere -30 und +30 Grad, aus der Strahlungsauskopplungsschicht ausgekoppelte Strahlung deutlich erhöht werden.

Der Abstand zwischen den beiden beabstandeten Teilschichten der Strahlungsauskopplungsschicht ist üblicherweise maximal 50 pm; meist ist der Abstand auch zumindest 0,5 $\mu$m. Um die Dicke der strahlungsemittierenden Vorrichtung gering zu halten sind möglichst kleine Abstände sinnvoll. Ferner ist bei geringeren Abständen im Regelfall eine besserer Zusammenhalt der gesamten Vorrichtung und insbesondere der beiden Teilschichten und damit eine verbesserte mechanische Stabilität zu verzeichnen.

Eine Beabstandung der beiden Teilschichten der lichtauskoppelnden Schicht kann beispielsweise erfolgen, in dem in regelmäßigen (oder auch unregelmäßigen) Abständen auf der ersten Teilschicht punktförmige Tropfen eines Klebstoffs (insbesondere eines transparenten Klebstoffs) aufgebracht werden und über diese Klebstoffpunkte dann eine Verbindung mit der zweiten Teilschicht der Strahlungsauskopplungsschicht erfolgt. Alternativ kann auch zur Einstellung der Beabstandung eine andere Stützstruktur, insbesondere eine Stützstruktur aus einem transparenten Material zwischen den beiden Teilschichten angeordnet sein. Möglich ist hierbei jegliches Material, insbesondere jegliches transparente Material. Eine stoffschlüssige Verbindung der beiden Teilschichten muss hierbei nicht über die Stützstruktur erfolgen oder kann z.B. nur teilweise über die Stützstruktur erfolgen. Wesentlich ist, dass der Anteil der einander zugewandten Oberflächen der beiden Teilschichten in möglichst geringem Umfang mit der Stützstruktur bedeckt ist. Vorteilhaft sind daher Stützstrukturen, die zum einen eine gleichmäßige Beabstandung über die gesamten einander zugewandten Oberflächen der Teilschichten gewährleisten, die andererseits aber möglichst wenig Platz einnehmen. Beispielsweise kann die Stützstruktur in den Randbereichen (z.B. in Form einer Klebespur) vorliegen. Ferner kann die Stützstruktur darin bestehen, dass die Teilschicht, die die geometrischen Strukturelemente enthält und die Schichtenfolge der Funktionsschichten mit der darauf angeordneten zweiten Teilschicht in einen Rahmen eingespannt werden. Schließlich kann auch die der zweiten Teilschicht zugewandte Grenzfläche der Teilschicht, die die geometrischen Strukturelemente enthält, absichtlich so gewählt werden, dass auf dieser Grenzfläche eine Textur vorhanden ist, die eine Ausbildung der Beabstandung ermöglicht.

Die Dicke einer Strahlungsauskopplungsschicht, in der voneinander beabstandete Teilschichten vorliegen unterscheidet sich nicht von den vorstehend für eine Strahlungsauskopplungsschicht ohne beabstandete Teilschichten angegebenen Werten.

In einer weiteren Ausführungsform enthält die strahlungsemittierende Vorrichtung ein ultraviolette Strahlung (UV) absorbierendes Element. Das UV-absorbierende Element kann in einer UV-Schutz-Schicht bestehen, die beispielsweise auf der der Strahlungsauskopplungsschicht zugewandten Seite eines Substrats angeordnet sein kann. Sie kann allerdings auch in einem Folienverbund mit der Strahlungsauskopplungsschicht enthalten sein und beispielsweise zwischen zwei Teilschichten der Strahlungsauskopplungsschicht bzw. zwischen einer Teilschicht und dem Beabstandungsmedium oder aber auch auf der der aktiven Schicht zugewandten Seite der Strahlungsauskopplungsschicht angeordnet sein. Ferner kann die Strahlungsauskopplungsschicht selbst durch Zusatz von einem oder mehreren Additiven, die UV-absorbierend wirken, ausgebildet sein. Auch die Matrix, die für die Strahlungsauskopplungsschicht Verwendung findet, kann UV-absorbierend ausgebildet sein.

Als Additiv, das UV-absorbierend wirkt, können beispielsweise 0,01 bis 0,5 Gewichtsprozent eines UV-Absorbers ausgewählt aus den Klassen der Benzotriazole, Triazine und Diarycyanoacrylate der für die Strahlungsauskopplungsschicht oder eine Teilschicht verwendeten Matrix zugesetzt werden.

Ein UV-absorbierendes Material hat den Vorteil, dass bei OLEDs die organische, zur Strahlungserzeugung vorgesehene Schicht nicht durch UV-Strahlung geschädigt werden kann, was zu einem beschleunigten Defekt des Bauelements führen kann.

Durch die UV-absorbierenden Materialien kann eine Alterung zumindest verlangsamt werden.

Die Strahlungsauskopplungsschicht bzw. die Teilschichten der Strahlungsauskopplungsschicht bzw. des Folienverbunds, der die Strahlungsauskopplungsschicht bildet können zusätzlich Verarbeitungshilfsmittel enthalten. Insbesondere können Entformungsmittel, Fließmittel, Stabilisatoren wie Thermostabilisatoren, Antistatika und/oder optische Aufheller enthalten sein.

Geeignete Stabilisatoren sind beispielsweise Phosphine, Phosphite oder Si enthaltende Stabilisatoren und weitere in EP-A 0 500 496 beschriebene Verbindungen. Beispielhaft seien Triphenylphosphite, Diphenylalkylphosphite, Phenyldialkylphosphite, Tris-(nonylphenyl)phosphit, Tetrakis-(2,4-di-tert.-butylphenyl)-4,4'-biphenylen-diphosphonit, Bis(2,4-dicumylphenyl)petaerythritoldiphosphit und Triarylphosphit genannt. Besonders bevorzugt sind Triphenylphosphin und Tris-(2,4-di-tert.-butylphenyl)phosphit.

Geeignete Entformungsmittel sind beispielsweise die Ester oder Teilester von ein- bis sechswertigen Alkoholen, insbesondere des Glycerins, des Pentaerythrits oder von Guerbetalkoholen.

Einwertige Alkohole sind beispielsweise Stearylalkohol, Palmitylalkohol und Guerbetalkohole, ein zweiwertiger Alkohol ist beispielsweise Glycol, ein dreiwertiger Alkohol ist beispielsweise Glycerin, vierwertige Alkohole sind beispielsweise Pentaerythrit und Mesoerythrit, fünfwertige Alkohole sind beispielsweise Arabit, Ribit und Xylit, sechswertige Alkohole sind beispielsweise Mannit, Glucit (Sorbit) und Dulcit.

Die Ester sind bevorzugt die Monoester, Diester, Triester, Tetraester, Pentaester und Hexaester oder deren Mischungen, insbesondere statistische Mischungen, aus gesättigten, aliphatischen $C_{10}$ bis $C_{36}$-Monocarbonsäuren und gegebenenfalls Hydroxy-Monocarbonsäuren, vorzugsweise mit gesättigten, aliphatischen $C_{14}$ bis $C_{32}$-Monocarbonsäuren und gegebenenfalls Hydroxy-Monocarbonsäuren.

Die kommerziell erhältlichen Fettsäureester, insbesondere des Pentaerythrits und des Glycerins, können herstellungsbedingt weniger als 60 % unterschiedlicher Teilester enthalten.

Gesättigte, aliphatische Monocarbonsäuren mit 10 bis 36 C-Atomen sind beispielsweise Caprinsäure, Laurinsäure, Myristinsäure, Palmitinsäure, Stearinsäure, Hydroxystearinsäure, Arachinsäure, Behensäure, Lignocerinsäure, Cerotinsäure und Montansäuren.

In einer weiteren Ausführungsform ist mit dem erfindungsgemäßen Bauelement ein antistatisch wirkendes Element vorgesehen, das insbesondere auf der Strahlungsauskoppelseite der Strahlungsauskopplungsschicht angeordnet ist. Hierdurch können Schmutzanlagerungen am Bauelement vermindert werden. Besonders vorteilhaft ist es, die Strahlungsauskopplungsschicht oder die die Mikrostrukturierung enthaltende Teilschicht antistatisch auszubilden. Elektrostatisch verursachte Anlagerungen an der Strahlungsauskopplungsschicht, die sich nachteilig auf die austrittsseitige Strahlungsleistungsverteilung auswirken können, werden so vermindert.

Beispiele für geeignete Antistatika sind kationaktive Verbindungen, beispielsweise quartäre Ammonium-, Phosphonium- oder Sulfoniumsalze, anionaktive Verbindungen, beispielsweise Alkylsulfonate, Alkylsulfate, Alkylphosphate, Carboxylate in Form von Alkali- oder Erdalkalimetallsalzen, nichtionogene Verbindungen, beispielsweise Polyethylenglykolester, Polyethylenglykolether, Fettsäureester, ethoxylierte Fettamine. Bevorzugte Antistatika sind quartäre Ammonium-Verbindungen, wie z.B. Dimethyldiisopropylammoniumperfluorbutansulfonat.

In einer weiteren Ausführungsform ist auf der mikrostrukturierten Seite der Strahlungsauskopplungsschicht noch eine Schutzschicht angeordnet. Die Schutzschicht kann insbesondere plan ausgebildet sein (und weißt bevorzugt zwei planparallele Hauptflächen auf) und hat den Effekt, dass eine Verschmutzung der strahlungsemittierenden Vorrichtung, insbesondere der Zwischenräume zwischen den Erhebungen der geometrischen Strukturelemente vermieden werden kann und so eine hohe Stabilität des Wirkungsgrads der Strahlungsauskopplung aus der strahlungsemittierenden Vorrichtung möglich ist. Außerdem übt die Schutzschicht eine schützende Wirkung gegenüber mechanischen Belastungen, wie beispielsweise Verkratzen aus. Die Schutzschicht kann beispielsweise eine Dicke von 10 bis 1000 $\mu$m haben, so dass eine dünne Ausgestaltung der gesamten strahlungsemittierenden Vorrichtung möglich ist.

Ebenso wie das Substrat kann die Schutzschicht aus einem Material gebildet sein, das aus der Gruppe von Glas, Quarz, Kunststoff und Kunststoff mit Diffusionsbarriereschichten sowie Metall ausgewählt ist. Damit ist eine stabile, einfach herstellbare und kostengünstige Lösung für das Substrat und/oder die Schutzschicht möglich.

In einer weiteren Ausführungsform ist die strahlungsemittierende Vorrichtung, insbesondere die OLED, zur Beleuchtung, insbesondere zur großflächigen Beleuchtung vorgesehen. Die Vorrichtung ist dann insbesondere flächenförmig ausgebildet.

Dabei kann flächenförmig ausgebildet bedeuten, dass sich die strahlungsemittierende Vorrichtung zusammenhängend über einen Flächenbereich erstreckt, der zumindest eine Fläche von einem oder mehreren Quadratmillimetern, üblicherweise einem oder mehreren Quadratzentimetern und häufig einem oder mehreren Quadratdezimetern (z.B. zwei bis zehn Quadratdezimetern) aufweist. Es ist damit möglich sehr flache strahlungsemittierende Vorrichtungen zur großflächigen Beleuchtung herzustellen.

Strahlungsemittierende Vorrichtungen, bei denen die ausgekoppelte Strahlung in Beobachtungswinkeln zwischen -30 und +30 Grad (bezogen auf die Richtung der Flächennormale) gegenüber der von einem Lambertschen Strahler erhöht, insbesondere deutlich erhöht, ist, eignen sich insbesondere als Licht- bzw. Strahlungsquellen, die vom zu bestrahlenden Objekt verhältnismäßig weit entfernt angeordnet sind (z.B. als Deckenleuchten in Räumen). Strahlungsemittierende Vorrichtungen, bei denen die ausgekoppelte Strahlung auch in Beobachtungswinkeln zwischen -30 und -45 Grad bzw. zwischen +30 und +45 Grad (bezogen auf die Richtung der Flächennormale) gegenüber der von einem Lambertschen Strahler erhöht, insbesondere deutlich erhöht, ist, eignen sich insbesondere als Licht- bzw. Strahlungsquellen, die relativ nahe am zu bestrahlenden Objekt angeordnet sind (etwa task lights z.B. für die Arbeitsplatz- oder Esstischbeleuchtung).

Insgesamt bietet die erfindungsgemäße strahlungsemittierende Vorrichtung mit Strahlungsauskopplungsschicht eine Vielzahl von oben und im Folgenden dargelegten Vorteilen. Weitere Merkmale, Vorteile und Zweckmäßigkeiten der Erfindung ergeben sich aus der folgenden Beschreibung der Ausführungsbeispiele in Verbindung mit den Figuren.

Figur 1 zeigt ein Ausführungsbeispiel einer erfindungsgemäßen strahlungsemittierenden Vorrichtung anhand einer schematischen Schnittansicht.

Figur 2 zeigt ein Ausführungsbeispiel eines erfindungsgemäßen strahlungsemittierenden Bauelements mit dargestelltem Strahlungsverlauf.

Figur 3 zeigt ein weiteres Ausführungsbeispiel der erfindungsgemäßen strahlungsemittierenden Vorrichtung mit eingezeichnetem Strahlverlauf.

Figur 4 und 4 A zeigt einen Schnitt durch eine Ausführungsform einer Strahlungsauskopplungsschicht des erfindungsgemäßen Bauteils.

Figur 5 A-C zeigt die Abhängigkeit der ausgekoppelten Strahlungsleistung vom Beobachtungswinkel für die erfindungsgemäßen Vorrichtungen.

Figur 6 zeigt die Abhängigkeit der CIE-Farbkoordinaten x und y vom Beobachtungswinkel für verschiedene Ausführungsformen der erfindungsgemäßen Vorrichtung sowie für eine Vorrichtung mit einer Strahlungsauskopplungsschicht ohne Mikrostrukturierung.

Gleiche, gleichartige und gleich wirkende Elemente sind in den Figuren mit gleichen Bezugszeichen versehen.

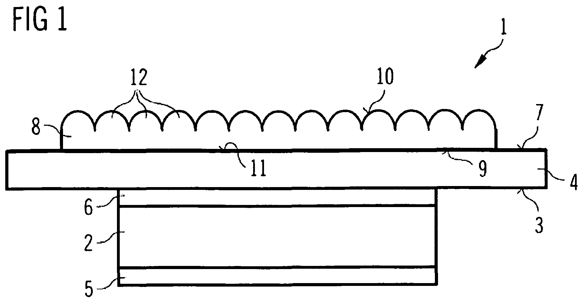

Figur 1 zeigt ein Ausführungsbeispiel eines erfindungsgemäßen strahlungsemittierenden Bauelements anhand einer schematischen Schnittansicht. Das strahlungsemittierende Bauelement 1 ist jeweils als OLED ausgeführt. Das Bauelement 1 umfasst eine zur Strahlungserzeugung ausgebildete organische Schicht 2 oder einen entsprechenden Schichtstapel mit einer Mehrzahl organischer Schichten. Die organische Schicht 2 ist auf einer ersten Hauptfläche 3 eines Substrats 4 des strahlungsemittierenden Bauelements angeordnet und mit diesem verbunden.

Zur Ladungsträgerinjektion in die organische Schicht 2 ist diese elektrisch leitend mit einer ersten Elektrode 5, z.B. der Kathode, und einer zweiten Elektrode 6, z.B. der Anode, verbunden. Über diese Elektroden 5, 6 können der organischen Schicht Ladungsträger - Elektronen bzw. Löcher - zur Strahlungserzeugung durch Rekombination in der organischen Schicht 2 zugeführt werden. Die Elektroden 5 und 6 sind vorzugsweise schichtartig ausgebildet, wobei die organische Schicht besonders bevorzugt zwischen den Elektroden angeordnet ist. Die Elektroden und die organische Schicht 2 können auf die erste Hauptfläche 3 des Substrats aufgebracht sein.

Die organische Schicht beziehungsweise die organischen Schichten enthalten bevorzugt ein halbleitendes organisches Material. Beispielsweise enthält die organische Schicht ein halbleitendes Polymer. Geeignete organische oder organometallische Polymere umfassen: Polyfluorene, Polythiopene, Polyphenylene, Polythiophenvinylene, Poly-p-Phenylenvinylene, Polyspiro Polymere und ihre Familien, Copolymere, Derivate und Mischungen davon.

Alternativ oder ergänzend zu Polymermaterialien kann die organische Schicht ein niedermolekulares Material (sogenannte Small Molecules) enthalten. Geeignete Materialien mit niedrigem Molekulargewicht (niedermolekulare Materialien) sind beispielsweise Tris-8-aluminium-quinolinol-Komplexe, Irppy (Tris-(2-phenylpyridyl)Iridium-Komplexe) und/oder DPVBI (4,4'-Bis(2,2-diphenyl-ethen-1-yl)-diphenyl).

Das Substrat 4 ist strahlungsdurchlässig für in der organischen Schicht 2 erzeugte Strahlung ausgebildet. Mittels der organischen Schicht 2 wird vorzugsweise sichtbares Licht erzeugt. Beispielsweise wird als strahlungsdurchlässiges Substrat ein Glassubstrat, zum Beispiel aus Borofloat-Glas, oder ein Kunststoff-(Folien)Substrat, z.B. aus PMMA (Polymethylmethacrylat), eingesetzt.

Durch die der organischen Schicht 2 abgewandte zweite Hauptfläche 7 des Substrats 4 hindurch tretendes Licht kann aus dem Bauelement 1 auskoppeln. Mittels der zweiten Hauptfläche 7 kann insbesondere die Strahlungsaustrittsfläche des Bauelements gebildet sein. Auf der von dem Substrat 4 abgewandten Seite der organischen Schicht 2 kann weiterhin eine Spiegelschicht angeordnet sein. Diese reflektiert in der organischen Schicht vom Substrat weg verlaufende Strahlung vorzugsweise in Richtung des Substrats 4 zurück. Die im Betrieb des Bauelements über die Strahlungsaustrittsfläche austretende Strahlungsleistung kann so erhöht werden. Bevorzugt ist die erste Elektrode 5 als reflektierende Elektrode und damit zugleich als Spiegelschicht ausgebildet. Hierzu ist die Elektrode 5 vorzugsweise metallisch oder auf Legierungsbasis ausgeführt. Eine separate Spiegelschicht ist in den Figuren nicht explizit gezeigt.

Die Elektrode 5 kann gegebenenfalls als Mehrschichtstruktur ausgeführt sein. Bevorzugt ist eine der Schichten für die Ladungsträgerinjektion in die organische Schicht 2 und eine weitere Schicht der Elektrode als Spiegelschicht ausgebildet. Die Schicht für die Ladungsträgerinjektion ist zweckmäßigerweise zwischen der Spiegelschicht und der organischen Schicht angeordnet. Die Spiegelschicht und/oder die Ladungsträgerinjektionsschicht kann ein Metall, z.B. Au, Al, Ag oder Pt, enthalten oder daraus bestehen, wobei die beiden Schichten zweckmäßigerweise unterschiedliche Metalle enthalten. Gegebenenfalls ist auch eine Legierung, vorzugsweise mit mindestens einem der oben genannten Metalle für die (Mehrschicht)Elektrode 5 geeignet.

Die zweite Elektrode 6 ist zwischen dem Substrat 4 und der organischen Schicht 2 angeordnet. Für den Strahlungsdurchtritt ist diese Elektrode zweckmäßigerweise strahlungsdurchlässig ausgebildet. Beispielsweise enthält die Elektrode ein TCO. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, $SnO_2$ oder $In_2O_3$ gehören auch ternäre Metallsauerstoffverbindungen, wie beispielsweise $Zn_2SnO_4$, CdSnO3, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Auf der Strahlungsauskoppelseite des Bauelements 1, also der von der organischen Schicht 2 abgewandten Seite des Substrats 4, ist eine Strahlungsauskopplungsschicht 8 an dem Substrat befestigt. Die Strahlungsauskopplungsschicht 8 besitzt eine der aktiven Schicht (bzw. der organischen Schicht 2) zugewandte Seite 9 und eine Seite mit mikrostrukturierter Oberfläche 10. Die Strahlungsauskopplungsschicht 8 weist auf der Seite mit mikrostrukturierter Oberfläche 10 eine Mikrostrukturierung mit geometrischen Strukturelementen 12 auf.

Auf die Darstellung einer Verkapselung für die organische Schicht 2, die vorzugsweise auf der von der Strahlungsauskopplungsschicht 8 abgewandten Seite des Substrats 4 angeordnet ist, wurde aus Übersichtlichkeitsgründen verzichtet. Ebenso wurde aus Übersichtlichkeitsgründen verzichtet, eine gegebenenfalls enthaltene Schutzschicht für die Strahlungsauskopplungsschicht darzustellen. Eine Verkapselung kapselt die organische Schicht gegenüber schädlichen äußeren Einflüssen, wie Feuchtigkeit oder Sauerstoff, ab. Die Verkapselung kann z.B. als Dachkonstruktion ausgebildet sein.

Auch auf eine explizite Darstellung der elektrischen Kontaktierung des Bauelements wurde verzichtet. So kann z.B. eine Ansteuerschaltung des Bauelements auf dem Substrat - ebenfalls innerhalb der Verkapselung - angeordnet sein.

Auch kann das Bauelement gegebenenfalls eine Mehrzahl von vorzugsweise strukturierten, voneinander getrennten organischen Schichten oder Schichtstapeln umfassen. Die verschiedenen Schichten bzw. Schichtstapel können zur Erzeugung von verschiedenfarbigen Licht, z.B. rotem, grünem bzw. blauem Licht ausgebildet sein.

Zwischen der Strahlungsauskopplungsschicht 8 und dem Substrat 4 kann sich eine (nicht dargestellte Schicht) befinden, die beispielsweise eine Haftvermittlungsschicht, z.B. eine Kleberschicht sein kann. Hierfür können beispielsweise "optically clear laminating adhesive #8141" der Firma 3M verwendet werden.

Über die Strahlungsauskopplungsschicht 8 kann die aus dem in Figur 1 dargestellten Verbundbauelement im Betrieb ausgekoppelte Strahlungsleistung erhöht werden. Durch die Mikrostrukturierung der Strahlungsauskopplungsschicht 8 erfolgt an der Grenzfläche von Strahlungsauskopplungsschicht und Umgebungsmedium (also an der mikrostrukturierten Oberfläche 10) eine verstärkte Brechung des ausgekoppelten Lichts in Richtung des Normalenvektors der Fläche 9 der Strahlungsauskopplungsschicht 8.

Über Streuereignisse in den streuenden Regionen der Strahlungsauskopplungsschicht kann im Vergleich zu einer Strahlungsauskopplungsschicht, die derartige Regionen nicht enthält, durch statistische Strahlumlenkungen der Strahlenverlauf gestört werden. Insbesondere können die Auftreffwinkel von Strahlung auf die mikrostrukturierte Oberfläche der Strahlungsauskopplungsschicht breiter verteilt sein.

Weiterhin kann die Strahlungsleistungsverteilung auf der Strahlungsauskoppelseite des Bauelements mittels der Strahlungsauskopplungsschicht vereinfacht homogenisiert werden. Beispielsweise kann ein defekter Bereich der organischen Schicht, der bei fehlender Strahlungsauskopplungsschicht (mit Streu-Regionen) auf der Strahlungsauskopplungsseite als dunkler Bereich erscheinen würde über diffuse Lichtstreuung mittels der Strahlungsauskopplungsschicht bzw. den darin enthaltenen Regionen kompensiert werden. Eine Strahlungsauskopplungsschicht 8 kann an den jeweiligen, für geeignet befundenen Bauelementen befestigt werden, nachdem eine Vielzahl am Bauelement etwa bezüglich Funktionsfähigkeit oder eine ausreichenden Strahlungsleistung, getestet und ungeeignete Bauelemente aussortiert wurden. Im Gegensatz zu einem in den jeweiligen Bauelementen bereits in der Fertigung integrierten Steuerelement können so die Herstellungskosten aufgrund des verringerten Ausschusses gesenkt werden.

Das Bauelement 1 ist vorzugsweise zur Beleuchtung, insbesondere zur Allgemeinbeleuchtung ausgebildet. Gegenüber einem Einsatz bei Displays, bei denen die Trennschärfe zwischen einzelnen Pixeln gewahrt bleiben muss, kann eine Lichtauskopplungsschicht mit Streu-Regionen, die bei Displays ein Verschwimmen der Einzelpixel verursachen würde, bei Bauelementen zur Allgemeinbeleuchtung ohne wesentliche nachteilige Wirkung eingesetzt werden. Das Bauelement kann beispielsweise zur Innenraumbeleuchtung, zur Außenraumbeleuchtung oder in einer Signalleuchte eingesetzt werden.

Das Bauelement ist, insbesondere für den Einsatz in der Allgemeinbeleuchtung, zweckmäßigerweise zur Erzeugung sichtbarer Strahlung ausgebildet. Über die Lichtauskopplungsschicht kann die auskoppelseitige Leuchtdichte, die auskoppelseitige spezifische Lichtausstrahlung und/oder die auskoppelseitige Helligkeit erheblich gesteigert werden.

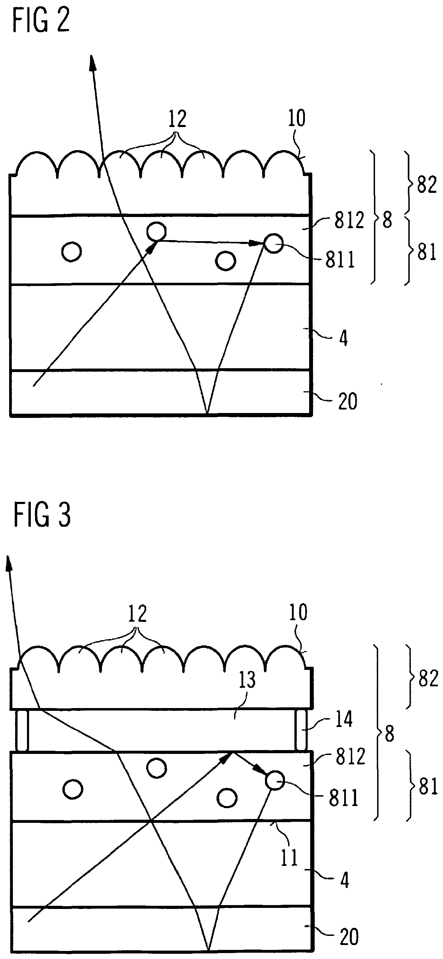

Die Figuren 2 und 3 zeigen jeweils ein Ausführungsbeispiel einer OLED mit dem Verlauf von emittierten Teilstrahlen.

Bei den Ausführungsbeispielen gemäß Figuren 2 und 3 umfasst die Lichtauskopplungsschicht 8 eine mit Streupartikeln 811 versetzte Teilschicht 81. Die Streupartikel 811 liegen in einer Matrix 812 vor, die vorzugsweise aus einem strahlungsdurchlässigen Polymer, z.B. Polycarbonat gebildet ist. Als Streupartikel eigenen sich insbesondere organische Polymerpartikel. Weiterhin umfasst die Lichtauskopplungsschicht 8 eine mit einer mikrostrukturierten Oberfläche 10 versehene Teilschicht 82. Angrenzend an die Teilschicht 81 ist ein Substrat 4 angeordnet. Angrenzend an die der Strahlungsauskopplungsschicht 8 abgewandte Substratseite ist ein OLED-stack 20 angeordnet; die vorstehend erläuterten organischen Schichten und Elektroden sind hierbei nicht dargestellt.

Weiterhin sind die Streupartikel 811 vorzugsweise strahlungsdurchlässig ausgeführt. Für eine Streuwirkung weisen die Streupartikel zweckmäßigerweise einen vom Brechungsindex des Matrixmaterials 812 verschiedenen Brechungsindex auf. Mit strahlungsdurchlässigen Streupartikeln kann demnach eine Streuwirkung durch Reflexion an der Grenzfläche zur Folienmatrix und/oder durch Brechung beim Eintritt in, beim Durchtritt durch und/oder beim Austritt aus dem Streupartikel erfolgen.

Die Streupartikel können einer Formmasse für das Matrixmaterial vor der Herstellung der Lichtauskopplungsschicht 8 in statistischer Verteilung beigemischt werden. Der Anteil an Streupartikeln in der Streufolie beträgt bevorzugt 50 Gewichtsprozent oder weniger.

Der Brechungsindex der Streupartikel weicht bevorzugt um 0,6 % oder mehr, besonders bevorzugt um 3,0 % oder mehr und mit besonderem Vorteil um 6 % oder mehr vom Brechungsindex des Matrixmaterials ab. Je größer die Abweichung ist, desto effizienter ist in der Regel die Strahlablenkung mittels der Streupartikel.

Für die Streupartikel eignen sich beispielsweise Polymer-Hohlpartikel, wobei eine Streuung durch Brechung hierbei hauptsächlich aufgrund des vergleichsweise hohen Brechungsindexunterschieds zwischen Hohlkörperinnenraum und Hohlkörperwand erfolgt. Werden polymere Materialien sowohl für die Matrix 812 als auch für die Umwandung des Hohlraums des Hohlpartikels eingesetzt, so weisen diese in der Regel einen vergleichsweise geringen Brechungsindexunterschied auf. Der Brechungsindexunterschied zwischen dem Material der Umwandung und dem Innenraum, der z.B. mit Gas, etwa Luft, gefüllt sein kann ist demgegenüber vereinfacht größer ausbildbar. Abweichend von den vorstehend beschriebenen Hohlpartikeln können selbstverständlich auch strahlungsdurchlässige Vollpartikel, insbesondere Polymerpartikel eingesetzt werden, die im Wesentlichen hohlraumfrei sind. In einer Ausführungsform weisen Polymerpartikel eine Kern-Schalen-Morphologie auf. Ferner können die Streupartikel auch aus einem anorganischen Material bestehen, insbesondere einem anorganischen Material mit hohem Brechungsindex, insbesondere einem Brechungsindex der um mindestens 10 % größer ist als der des Matrixmaterials. Als Beispiele sind etwa Titandioxid mit einem Brechungsindex von 2,6 und Aluminiumoxid mit einem Brechungsindex von 1,77 zu nennen.

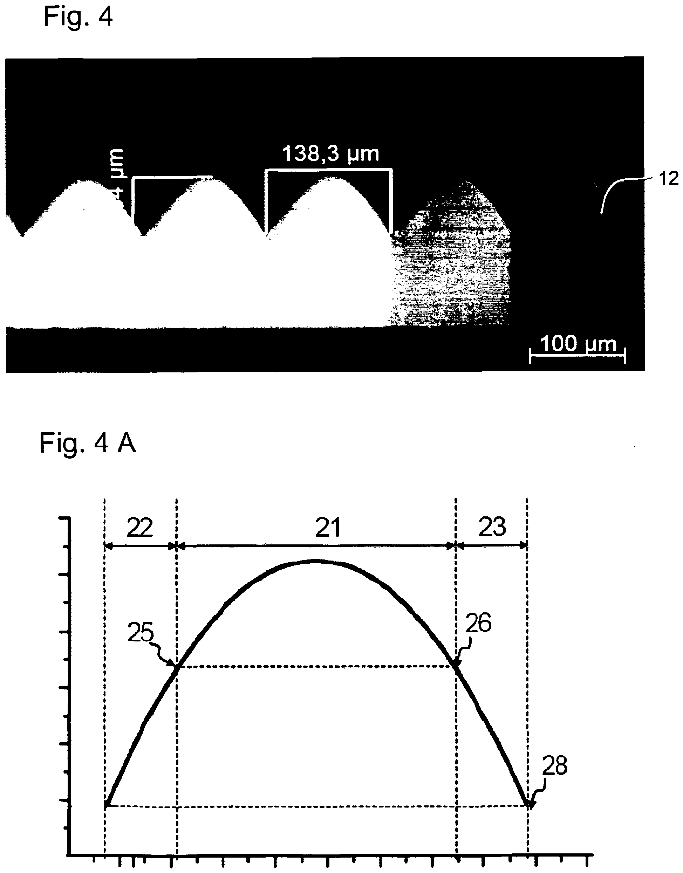

Die weiter vom Substrat entfernt liegende Teilschicht 82 der Strahlungsauskopplungsschicht 8 weist geometrische Strukturelemente 12 auf der Strahlungsauskopplungsseite 10 auf. Mittels dieser geometrischen Strukturelemente kann eine Ausrichtung der abgestrahlten Strahlung in Richtung bestimmter Betrachterwinkel erfolgen, insbesondere eine Ausrichtung in Richtung des auf den im Wesentlichen parallel zueinander vorliegenden Flächen von Substrat und der dem Substrat zugewandten Seite der Strahlungsauskopplungsschicht senkrecht stehenden Normalenvektors. Für die Mikrostrukturierung eignet sich beispielsweise die in Figur 4 gezeigte Geometrie der geometrischen Strukturelemente 12.

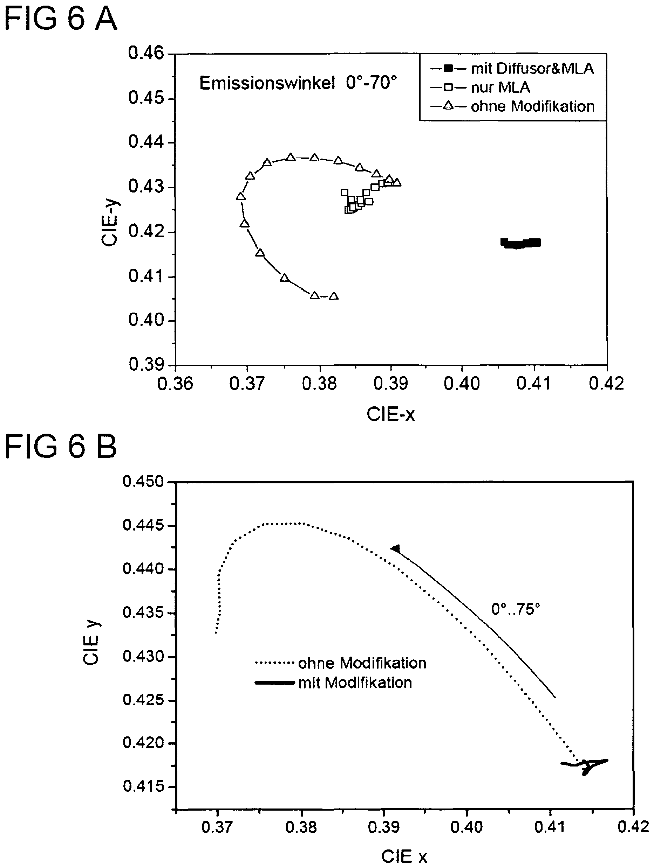

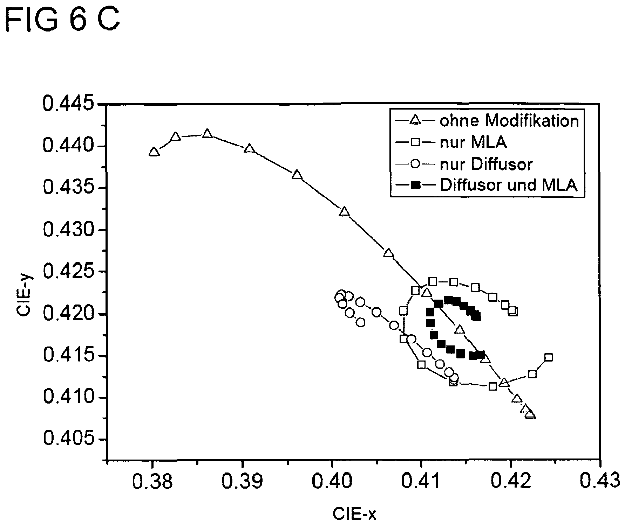

Figur 4 zeigt eine lichtmikroskopische Aufnahme eines (Quer)-Schnitts durch eine Ausführungsform einer Strahlungsauskopplungsschicht des erfindungsgemäßen Bauteils. In Figur 6 ist zu erkennen, dass die geometrischen Strukturelemente 12 im Bereich der Sockel eine Steigung besitzen, die mit der entsprechenden Steigung des Sockels eines benachbarten Strukturelements einen Winkel von etwa 60° ausbildet. Ferner weisen die geometrischen Strukturelemente in ihrem oberen Drittel eine deutlich stärkere Krümmung auf als in ihrem unteren Drittel.

Allgemeiner beschrieben ist das in Figur 4 gezeigte Strukturelement in folgender beispielhaften Ausführungsform beschrieben: In dieser beispielhaften Ausrührungsform wird ein geometrisches Strukturelement gewählt, bei dem die Lichtauskopplungsfläche des Strukturelements mathematisch bestimmt wird. Zur mathematischen Bestimmung sind die bestimmenden Parameter die beiden - hier meist identischen - Akzeptanzwinkel sowie der Verkürzungsfaktor. Das Strukturelement bzw. dessen Lichtauskopplungsfläche wird gemäß nachfolgender Vorgehensweise mit den genannten Formeln konstruiert. Bei der beschriebenen Vorgehensweise handelt es sich um ein implizites Optimierungsproblem:

a) Berechnen der Öffnungswinkel im Medium $\theta_1$ und $\theta_2$ aus den Fresnelschen Gleichungen mittels der definierten Akzeptanzwinkel;

b) Konstruktion der beiden Parabeläste $P_1$ (22) mit den Öffnungswinkeln im Medium $\theta_1$ und $P_2$ (23) mit den Öffnungswinkeln im Medium $\theta_2$ gemäß der Gleichung:

$$y_{1,2} = \frac{\left(x \mp \cos\theta_{1,2}\right)^2}{2\left(1 \mp \sin\theta_{1,2}\right)} - \frac{1 \pm \sin\theta_{1,2}}{2}$$

wobei $\theta_{1,2}$ der Öffnungswinkel im Medium der linken ($\theta_1$) und rechten ($\theta_2$) Parabel, x die X-Koordinate, und $y_{1,2}$ die die Y-Koordinate der linken ($y_1$) und rechten ($y_2$) Parabel ist;

c) Berechnung der Endpunkte der Parabeläste $F_1$, $F_2$ (25,26) und $E_1$, $E_2$;

d) Drehung des Parabelastes $P_1$ um den Öffnungwinkel im Medium - $\theta_1$ und des Parabelastes $P_2$ um den Öffnungwinkel im Medium $\theta_2$ und Translation des Parabelastes $P_2$ längs der x-Achse;

e) optional im Falle einer asymmetrischen Variante mit $\theta_1 \neq \theta_2$ der Bestimmung der Neigung der durch die Punkte $E_1$ und $E_2$ bestimmten Neigungsfläche;

f) Bestimmung der effektiven Akzeptanzwinkel in Luft aus der in den Schritten a) bis e) konstruierten Geometrie;

g) Vergleich der effektiven Akzeptanzwinkel mit den definierten Akzeptanzwinkeln, und bei nicht ausreichender Genauigkeit (insbesondere einer Abweichung größer 0,001%) Wiederholung von Schritt a) bis f) mit korrigierten Akzeptanzwinkeln anstelle der definierten Akzeptanzwinkel in Schritt a), wobei die korrigierten Akzeptanzwinkeln ungleich sind den definierten Akzeptanzwinkeln, und wobei die korrigierten Akzeptanzwinkel so gewählt werden, dass die effektiven Akzeptanzwinkel aus Schritt f) mit den definierten Akzeptanzwinkeln übereinstimmen; und

h) beim Erreichen ausreichender Genauigkeit (insbesondere einer Abweichung der effektiven Akzeptanzwinkel von den definierten Akzeptanzwinkeln von 0,001% oder weniger) Verkürzung der Parabeln in y-Richtung auf das durch den Verkürzungsfaktor bestimmte Maß mit den neuen Endpunkten $E_3$ und $E_4$ (27 und 28) .

i) optional: Ersetzen der durch die Punkte $F_1$ und $F_2$ (25, 26) begrenzten Kante durch eine Polynom n-ter Ordnung (21), das stetig differenzierbar angeschlossen wird.

Insbesondere ist das geometrische Strukturelement dieser Ausrührungsform dadurch gekennzeichnet, dass der definierte Akzeptanzwinkel $\theta_1$ zwischen 5° und 60° und dass der definierte Akzeptanzwinkel $\theta_2$ zwischen 5° und 60° liegt.

Das geometrische Strukturelement dieser Ausrührungsform kann dadurch gekennzeichnet sein, dass in Schritt h) die Verkürzung einfaches Abschneiden ist.

Das geometrische Strukturelement dieser Ausrührungsform kann dadurch gekennzeichnet sein, dass in Schritt h) die Verkürzung eine Stauchung der Geometrie entlang der y-Achse um den durch den Verkürzungsfaktor bestimmten Faktor ist.

Das geometrische Strukturelement dieser Ausrührungsform kann dadurch gekennzeichnet sein, dass $\theta_1 = \theta_2$ ist.

Das geometrische Strukturelement dieser Ausrührungsform kann dadurch gekennzeichnet sein, dass die Lichtauskopplungsfläche des Strukturelements einen stetig polynomischen Abschluss aufweist, der z.B. ein Polynom n-ter Ordnung ist, insbesondere ein Polynom vierter Ordnung, der stetig differenzierbar in den Punkten $F_1$ und $F_2$ ist.

Das geometrische Strukturelement dieser Ausrührungsform kann dadurch gekennzeichnet sein, dass die Lichtauskopplungsfläche des Strukturelements einen stetigen Abschluss aufweist, der sich durch eine Parabel, Hyperbel, Kreisfunktion Sinosoidalfunktion oder Gerade beschreiben lässt.

Das geometrische Strukturelement dieser Ausrührungsform kann schließlich auch dadurch gekennzeichnet sein, dass die Gesamtperiode in einem Bereich zwischen 10$\mu$m und 1mm, bevorzugt 30$\mu$m - 500 $\mu$m, besonders bevorzugt 50$\mu$m 300$\mu$m liegt.

Das in Figur 4 bzw. 4A gezeigte Strukturelement kann beispielsweise folgende Parameter aufweisen: Akzeptanzwinkel: 40°, Verkuerzungsfaktor: 0,1, Polymer: Polycarbonat, Polynombereich (21): Polynom 2. Ordnung.

Figur 3 zeigt denselben Aufbau wie Figur 2, allerdings weist die Vorrichtung zwischen der die mikrostrukturierte Oberfläche 10 enthaltenden Teilschicht 82 und der die Lichtstreupartikel 811 enthaltenden Teilschicht 81 einen mit einem Beabstandungsmedium, insbesondere einem gasförmigen Beabstandungsmedium, gefüllten Spalt 13 auf. Der im wesentlichen parallele Verlauf der einander zugewandten Seiten der Teilschichten 81 und 82 bzw. der über die gesamte Fläche im wesentlichen gleiche Abstand der beiden Teilschichten kann mittels einer Stützstruktur 14 erreicht werden. Durch eine Anordnung mit einem Spalt 13 wird der Strahlungsverlauf von Strahlung, die in Figur 2 in einem flachen Winkel auf die Grenzfläche zur Teilschicht 82 auftreffen würde deutlich verändert. Wie in Figur 3 zu sehen, werden derartige Strahlen an der Grenzfläche zum Beabstandungsmedium totalreflektiert und dann durch die Streupartikel bzw. eine verspiegelte Schicht im Bereich der OLED 20 in einem steileren Winkel in Richtung der Grenzfläche zum Beabstandungsmedium gelenkt. Durch die in der Teilschicht 82 enthaltenen geometrischen Strukturelemente wird dieser Strahl dann in etwa in Richtung des vorstehend beschriebenen Normalenvektors umgelenkt.

Die Pfeile in den Figuren 2 und 3 symbolisieren exemplarisch Strahlengänge in der Strahlungsauskopplungsschicht 8 und dem erfindungsgemäßen Bauelement, wobei bei den mit Streupartikeln 811 versehenen Teilschichten auf eine Darstellung eines Strahlungsdurchtritts durch die Partikel aus Übersichtlichkeitsgründen verzichtet wurde.

Die Strahlungsauskopplungsschicht 8 weist insbesondere eine Dicke zwischen 25 $\mu$m und 500 $\mu$m auf und liegt üblicherweise zwischen 25 $\mu$m und 300 $\mu$m. Diese Dickenangaben umfassen auch die geometrischen Strukturelemente und sind zum einen hinsichtlich der Streuwirkung und zum anderen hinsichtlich einer Erhöhung der mechanischen Gesamtstabilität des Verbundbauelements besonders geeignet. Insbesondere kann durch eine nachträglich an einem vorgefertigten Bauelement befestigte Strahlungsauskopplungsschicht die Stabilität des Bauelements auch bei einem zersplitterten Substrat gewährleistet bleiben. Zudem kann die Verletzungsgefahr durch Splitter aufgrund der Splitterschutzwirkung der Strahlungsauskopplungsschicht verringert werden.

Bei Ausführungsformen mit zwei Teilschichten weist die mikrostrukturierte Teilschicht insbesondere eine Dicke von mindestens 10 $\mu$m, im Regelfall von mindestens 25 $\mu$m auf. Die nicht mikrostrukturierte Teilschicht weist insbesondere eine Dicke von mindestens 10 $\mu$m, im Regelfall von mindestens 25 $\mu$m auf; enthält die nicht mikrostrukturierte Teilschicht lichtstreuende Regionen, insbesondere Streupartikel, so weist die Teilschicht insbesondere eine Schichtdicke von mindestens 25 $\mu$m auf. Zumindest sollten die beiden Teilschichten eine Dicke besitzen, die größer ist als die Wellenlänge der von der erfindungsgemäßen strahlungsemittierenden Vorrichtung emittierten Strahlung.

Für eine optimierte Einkopplung von Strahlung aus dem Bauelement 1 in die Strahlungsauskopplungsschicht 8 ist die dem Bauelement zugewandte Oberfläche 11 der Strahlungsauskopplungsschicht zweckmäßigerweise eben und insbesondere unstrukturiert ausgebildet. Dasselbe gilt beim Vorliegen von voneinander beabstandeten Teilschichten auch für die einander zugewandten Flächen der Teilschichten.

Um den Strahlungsübertritt aus dem Substrat 4 in die Strahlungsauskopplungsschicht 8 zu erleichtern, ist das Material der Strahlungsauskopplungsschicht an das Substrat zweckmäßigerweise brechungsindexangepasst. Hierzu eignet sich insbesondere ein Polycarbonat. Polycarbonate weisen einen Brechungsindex von 1,58 bis 1,59 auf. Dieses Material ist an ein Glassubstrat, z.B. ein Borofloatglas-Substrat mit einem Brechungsindex von 1,54 gut brechungsindexangepasst.

Alternativ oder ergänzend kann auf einem Brechungsindexanpassungsmaterial, etwa ein optisches Gel, zwischen dem Substrat 4 und der Strahlungsauskopplungsschicht 8 angeordnet werden. Idealerweise ist im Falle einer Befestigung der Strahlungsauskopplungsschicht 8 an dem Bauelement mittels einer Haftvermittlungsschicht die Haftvermittlungsschicht zur Brechungsindexanpassung ausgeführt. Hierzu weist der Haftvermittler bevorzugt einen Brechungsindex auf, der nicht um mehr als 20 %, bevorzugt nicht mehr als 10 % außerhalb eines durch die Brechungsindices des Substrats 4 und des Materials der Strahlungsauskopplungsschicht 8 begrenzten Intervalls liegt. Vorzugsweise weist das Brechungsindexanpassungsmaterial einen Brechungsindex auf, der zwischen dem des Substrats und dem der Strahlungsauskopplungsschicht bzw. der Matrix der Strahlungsauskopplungsschicht liegt.

Im Folgenden werden Strahlungsauskopplungsschichten beschrieben, die für ein erfindungsgemäßes Bauelement, insbesondere ein Bauelement, das sichtbares Licht emittiert, besonders geeignet sind.

Für transparente Streupartikel ((Streu)Pigmente) der Strahlungsauskopplungsschicht können Acrylate oder Kern-Schale Acrylate eingesetzt werden. Diese verfügen bevorzugt über eine ausreichend hohe thermische Stabilität, z.B. bis mindestens 300°C, um bei den Verarbeitungstemperaturen des transparenten Kunststoffs, z.B. des Polycarbonats, nicht zersetzt zu werden.

Darüber hinaus sollten die Streupigmente über keine Funktionalitäten verfügen, die zu einem Abbau der Polymerkette des transparenten Kunststoffs, z.B.des Polycarbonats, führen. So können z.B. Paraloid® der Fa. Röhm & Haas oder Techpolymer® der Fa. Sekisui gut zur Pigmentierung von transparenten Kunststoffen eingesetzt werden. Aus diesen Produktlinien stehen eine Vielzahl verschiedener Typen zur Verfügung. Bevorzugt werden Acrylate aus der Techpolymer-Reihe eingesetzt.

Die Lichtauskopplungsschicht ist vorzugsweise als Kunststofffolie ausgeführt, die aus einer oder mehreren Teilschichten besteht. Mindestens eine (Teil-)Schicht der Lichtauskopplungsschicht enthält in einer Ausführungsform transparente polymere Teilchen mit einem vom Matrixmaterial unterschiedlichen Brechungsindex. Die Schicht enthält insbesondere 50 bis 99,99 Gew.-%, bevorzugt 70 bis 99,99 Gew.-% eines transparenten Kunststoffs, insbesondere Polycarbonat, und 0,01 bis 50 Gew.-%, bevorzugt 0,01 bis 30 Gew.-%, polymerer Teilchen. Die Teilchen weisen bevorzugt eine mittlere Teilchengröße im Wesentlichen zwischen 1 und 100 $\mu$m, bevorzugt zwischen 1 und 50 $\mu$m auf.

Das Einbringen der Mikrostrukturierung in die Oberfläche der Strahlungsauskopplungsschicht erfolgt bevorzugt mittels geprägter Metallwalzen.

Die erfindungsgemäße Strahlungsauskopplungsschicht kann einstückig sein; es kann sich auch um einen Mehrschichtverbund aus mindestens zwei Folien handeln. Dieser Verbund kann durch Extrusion hergestellt werden. Alternativ können separat vorgefertigte Folien aufeinander angeordnet und miteinander verbunden werden (sogenanntes Kaschieren oder Laminieren).

Zur Herstellung einer Folie durch Extrusion wird das Kunststoffgranulat, beispielsweise das Polycarbonatgranulat einem Fülltrichter eines Extruders zugeführt und gelangt über diesen in das Plastifiziersystem bestehend aus Schnecke und Zylinder. Im Plastifiziersystem erfolgt das Fördern und Aufschmelzen des Kunststoffmaterials. Die Kunststoffschmelze wird durch eine Breitschlitzdüse gedrückt. Zwischen Plastifiziersystem und Breitschlitzdüse können eine Filtereinrichtung, eine Schmelzpumpe, stationäre Mischelemente und weitere Bauteile angeordnet sein. Die die Düse verlassende Schmelze gelangt auf einen Glättkalander.

Als Kunststoffe für die (Matrix der) Strahlungsauskopplungsschicht bzw. für die Teilschichten 81, 82 der Strahlungsauskopplungsschicht können alle transparenten Thermoplaste eingesetzt werden: Polyacrylate, Polymethylmethacrylate (PMMA; Plexiglas® von der Fa. Röhm), Cycloolefin-Copolymere (COC; Topas® von der Fa. Ticona; Zenoex® von der Fa. Nippon Zeon oder Apel® von der Fa. Japan Synthetic Rubber), Polysulfone (Ultrason® von der Fa. BASF oder Udel® von der Fa. Solvay), Polyester, wie z.B. PET oder PEN, Polycarbonat, Polycarbonat/Polyester-Blends, z.B. PC/PET, Polycarbonat/Polycyclohexylmethanolcyclohexandicarboxylat (PCCD; Xylecs® von der Fa. GE) und Polycarbonat/Polybutylenterephthalat (PBT)Blends.

Bevorzugt wird ein Polycarbonat eingesetzt. Dieses ist, wie oben bereits erläutert für die Brechungsindexanpassung an eine OLED besonders geeignet. Geeignete Polycarbonate für die Herstellung der Folie sind alle bekannten Polycarbonate. Dies sind Homopolycarbonate, Copolycarbonate und thermoplastische Polyestercarbonate. Ein geeignetes Polycarbonat hat bevorzugt ein mittleres Molekulargewicht $\overline{M}_w$ von 18.000 bis 40.000, vorzugsweise von 26.000 bis 36.000 und insbesondere von 28.000 bis 35.000, ermittelt durch Messung der relativen Lösungsviskosität in Dichlormethan oder in Mischungen gleicher Gewichtsmengen Phenol/o-Dichlorbenzol geeicht durch Lichtstreuung.

Die Herstellung der Polycarbonate erfolgt vorzugsweise nach dem Phasengrenzflächenverfahren oder dem Schmelze-Umesterungsverfahren.

Das Phasengrenzflächenverfahren zur Polycarbonatsynthese ist mannigfaltig in der Literatur beschrieben; beispielhaft sei auf H. Schnell, Chemistry and Physics of Polycarbonates, Polymer Reviews, Vol. 9, Interscience Publishers, New York 1964 S. 33 ff., auf Polymer Reviews, Vol. 10, "Condensation Polymers by Interfacial and Solution Methods", Paul W. Morgan, Interscience Publishers, New York 1965, Kap. VIII, S. 325, auf Dres. U. Grigo, K. Kircher und P. R- Müller "Polycarbonate" in Becker/Braun, Kunststoff-Handbuch, Band 3/1, Polycarbonate, Polyacetale, Polyester, Celluloseester, Carl Hanser Verlag München, Wien 1992, S. 118-145 sowie auf EP-A 0 517 044 verwiesen.

Geeignete Diphenole sind z.B. in den US-A -PS 2 999 835, 3 148 172, 2 991 273, 3 271 367, 4 982 014 und 2 999 846, in den deutschen Offenlegungsschriften 1 570 703, 2 063 050, 2 036 052, 2 211 956 und 3 832 396, der französischen Patentschrift 1 561 518, in der Monographie "H. Schnell, Chemistry and Physics of Polycarbonates, Interscience Publishers, New York 1964, S. 28ff; S.102ff", und in "D.G. Legrand, J.T. Bendler, Handbook of Polycarbonate Science and Technology, Marcel Dekker New York 2000, S. 72ff." beschrieben.

Die Herstellung von Polycarbonaten ist auch aus Diarylcarbonaten und Diphenolen nach dem bekannten Polycarbonatverfahren in der Schmelze, dem sogenannten Schmelzumesterungsverfahren, möglich, das z.B. in WO-A 01/05866 und WO-A 01/05867 beschrieben ist. Daneben werden Umesterungsverfahren (Acetatverfahren und Phenylesterverfahren) beispielsweise in den US-A 34 94 885, 43 86 186, 46 61 580, 46 80 371 und 46 80 372, in den EP-A 26 120, 26 121, 26 684, 28 030, 39 845, 39 845, 91 602, 97 970, 79 075, 14 68 87, 15 61 03, 23 49 13 und 24 03 01 sowie in den DE-A 14 95 626 und 22 32 977 beschrieben.

Geeignet sind sowohl Homopolycarbonate als auch Copolycarbonate. Zur Herstellung von Copolycarbonaten können auch 1 bis 25 Gew.-%, vorzugsweise 2,5 bis 25 Gew.-% (bezogen auf die Gesamtmenge an einzusetzenden Diphenolen), Polydiorganosiloxane mit Hydroxy-aryloxy-Endgruppen eingesetzt werden. Diese sind bekannt (z.B. aus der US 3 419 634) bzw. nach literaturbekannten Verfahren herstellbar. Die Herstellung Polydiorganosiloxanhaltiger Copolycarbonate wird z. B. in DE-OS 33 34 782 beschrieben.

Ferner sind Polyestercarbonate und Block-Copolyestercarbonate geeignet, wie sie z.B. in der WO 2000/26275 beschrieben sind. Aromatische Dicarbonsäuredihalogenide zur Herstellung von aromatischen Polyestercarbonate sind vorzugsweise die Disäuredichloride der Isopthalsäure, Terepthalsäure, Diphenylether-4,4'-dicarbonsäure und der Naphthalin-2,6-dicarbonsäure.

Die aromatischen Polyestercarbonate können sowohl linear als auch in bekannter Weise verzweigt sein (siehe dazu ebenfalls DE-OS 29 40 024 und DE-OS 30 07 934).

Die Polydiorganosiloxan-Polycarbonat-Blockpolymeren können auch eine Mischung aus Polydiorganosiloxan-Polycarbonat-Blockcopolymeren mit üblichen polysiloxanfreien, thermoplastischen Polycarbonaten sein, wobei der Gesamtgehalt an Polydiorganosiloxanstruktureinheiten in dieser Mischung ca. 2,5 bis 25 Gew.-% beträgt.

Derartige Polydiorganosiloxan-Polycarbonat-Blockcopolymere sind z.B. aus US-PS 3 189 662, US-PS 3 821 325 und US-PS 3 832 419 bekannt.

Bevorzugte Polydiorganosiloxan-Polycarbonat-Blockcopolymere werden hergestellt, indem man alpha, omega-Bishydroxyaryloxyendgruppen-haltige Polydiorganosiloxane zusammen mit anderen Diphenolen, gegebenenfalls unter Mitverwendung von Verzweigern in den üblichen Mengen, z. B. nach dem Zweiphasengrenzflächenverfahren (s. dazu H. Schnell, Chemistry and Physics of Polycarbonates Polymer Rev. Vol. IX, Seite 27 ff, Interscience Publishers New York 1964) umsetzt, wobei jeweils das Verhältnis der bifunktionellen phenolischen Reaktanten so gewählt wird, dass daraus ein geeigneter Gehalt an aromatischen Carbonatstruktureinheiten und Diorganosiloxy-Einheiten resultiert. Derartige alpha, omega-Bishydroxyaryloxyendgruppen-haltige Polydiorganosiloxane sind z.B. aus US 3 419 634 bekannt.

Als polymere Teilchen auf Acrylatbasis für Streupartikel werden bevorzugt solche eingesetzt, wie sie in EP-A 634 445 offenbart werden.

Die polymeren Teilchen haben einen Kern aus einem kautschukartigen Vinylpolymeren. Das kautschukartige Vinylpolymere kann ein Homo- oder Copolymeres von einem beliebigen der Monomeren sein, die wenigstens eine ethylenartig ungesättigte Gruppe besitzen und die eine Additionspolymerisation - wie sie allgemein bekannt ist - unter den Bedingungen der Emulsionspolymerisation in einem wässrigen Medium eingehen. Solche Monomere sind in US 4 226 752, Spalte 3, Zeilen 40 - 62, aufgelistet.

Am meisten bevorzugt enthalten die polymeren Teilchen einen Kern aus kautschukartigem Alkylacrylatpolymeren, wobei die Alkylgruppe 2 bis 8 Kohlenstoffatome aufweist, wahlweise copolymerisiert mit 0 bis 5 % Vernetzer und 0 bis 5 % Pfropfvernetzer, bezogen auf das Gesamtgewicht des Kerns. Das kautschukartige Alkylacrylat ist bevorzugt mit bis zu 50 % von einem oder mehreren copolymerisierbaren Vinylmonomeren copolymerisiert, beispielsweise den zuvor genannten. Geeignete vernetzende und pfropfvernetzende Monomere sind beispielsweise in EP-A 0 269 324 beschrieben sind.

Die polymeren Teilchen enthalten einen oder mehrere Mäntel. Dieser eine Mantel oder diese mehreren Mäntel sind bevorzugt aus einem Vinylhomo- oder -copolymeren hergestellt. Geeignete Monomere zur Herstellung des/der Mantels/Mäntel sind im US-Patent No. 4 226 752, Spalte 4, Zeilen 20 - 46, aufgeführt, wobei auf die Angaben hierüber Bezug genommen wird. Ein Mantel oder mehrere Mäntel sind bevorzugt ein Polymeres aus einem Methacrylat, Acrylat, Vinylaren, Vinylcarboxylat, Acrylsäure und/oder Methacrylsäure.

Die polymeren Teilchen sind nützlich, um dem transparenten Kunststoff, bevorzugt Polycarbonat, Lichtstreueigenschaften zu verleihen.

Die polymeren Teilchen haben vorzugsweise einen Durchschnittsteilchendurchmesser (mittleren Teilchendurchmesser oder - größe) von wenigstens 0,5 $\mu$m, bevorzugt von wenigstens 1 $\mu$m bis höchstens 100 $\mu$m, mehr bevorzugt von 2 bis 50 $\mu$m, am meisten bevorzugt von 2 bis 30 $\mu$m. Unter "Durchschnittsteilchendurchmesser" (mittlerer Teilchendurchmesser) ist der Zahlendurchschnitt zu verstehen. Bevorzugt haben wenigstens 90 %, am meisten bevorzugt wenigstens 95 % der polymeren Teilchen einen Durchmesser von mehr als 1 $\mu$m und kleiner als 100 $\mu$m. Die polymeren Teilchen sind bevorzugt ein freifließendes Pulver, bevorzugt in kompaktierter Form.

Die polymeren Teilchen können folgendermaßen hergestellt werden: Im Allgemeinen wird wenigstens eine Monomerenkomponente des Kernpolymeren der Emulsionspolymerisation unter Bildung von Emulsionspolymerteilchen unterworfen. Die Emulsionspolymerteilchen werden mit derselben oder einer oder mehreren anderen Monomerenkomponenten des Kernpolymeren gequollen, und das/die Monomere werden innerhalb der Emulsionspolymerteilchen polymerisiert. Die Stufen des Quellens und Polymerisierens können wiederholt werden, bis die Teilchen auf die gewünschte Kerngröße angewachsen sind. Die Kernpolymerteilchen werden in einer zweiten wässrigen Monomerenemulsion suspendiert, und es wird ein Polymermantel aus dem/den Monomeren auf die Polymerteilchen in der zweiten Emulsion polymerisiert. Ein Mantel oder mehrere Mäntel können auf dem Kernpolymeren polymerisiert werden. Die Herstellung von Kern/Mantel-Polymerteilchen ist in EP-A 0 269 324 und in den US-Patenten 3,793,402 und 3,808,180 beschrieben.

Die Strahlungsauskopplungsschicht wird vorzugsweise durch Extrusion hergestellt.

Zur Extrusion wird z.B. ein Polycarbonat-Granulat dem Extruder zugeführt und im Plastifizierungssystem des Extruders aufgeschmolzen. Die Kunststoffschmelze wird durch eine Breitschlitzdüse gedrückt und dabei verformt, im Walzenspalt eines Glättkalanders in die gewünschte endgültige Form gebracht und durch wechselseitige Kühlung auf Glättwalzen und der Umgebungsluft formfixiert. Die zur Extrusion verwendeten Polycarbonate mit hoher Schmelzeviskosität werden üblicherweise bei Schmelzetemperaturen von 260 bis 320°C verarbeitet, entsprechend werden die Zylindertemperaturen des Plastifizierzylinders sowie Düsentemperaturen eingestellt.

Durch Einsatz von einem oder mehrerer Seitenextruder und geeigneten Schmelzeadaptern vor der Breitschlitzdüse lassen sich Polycarbonatschmelzen verschiedener Zusammensetzung oder auch - wie vorstehend beschrieben - Schmelzen anderer Polymere übereinander legen und somit mehrschichtige Folien erzeugen (siehe beispielsweise EP-A 0 110 221 und EP-A 0 110 238).

Die Herstellung der Strahlungsauskopplungsschicht wird anhand des folgenden Beispiels näher erläutert: Zweischichtige Folie mit lichtstreuender Schicht und geometrischer Strukturschicht

Beispiel A) Herstellung eines Master-Batches durch Compoundierung:

Die Herstellung des Master-Batches erfolgt mit herkömmlichen Zweischnecken-Compoundierextrudern (z.B. ZSK 32) bei für Polycarbonat üblichen Verarbeitungstemperaturen von 250 bis 330°C.

Es wurde ein Master-Batch mit folgender Zusammensetzung hergestellt:

1. 80 Gew.-% Makrolon® 3108 550115 (Polycarbonat (PC) der Fa. Bayer MaterialScience AG)
2. 20 Gew.-% Streu-Teilchen (Techpolymer® MBX 5 der Fa. Sekisui) mit einer Teilchengröße von 2 bis 15 μm und einer mittleren Teilchengröße von 8 μm.

Die verwendete Anlage für die Herstellung der Strahlungsauskopplungsschichten besteht aus (i) einem Hauptextruder mit einer Schnecke von 105 mm Durchmesser (D) und einer Länge von 41xD; die Schnecke weist eine Entgasungszone auf; (ii) einem Dreiwalzen-Glättkalander mit horizontaler Walzenanordnung, wobei die dritte Walze um +/- 45° gegenüber der Horizontalen schwenkbar ist; (iii) einer Rollenbahn; (iv) einer Einrichtung zum beidseitigen Aufbringen von Schutzfolie; (v) einer Abzugseinrichtung; (vi) Aufwickelstation.

Es wurde folgende Lichtstreuende Zusammensetzung dem Hauptextruder zugeführt:

1. 50,0 Gew.-% Makrolon® 3108 550115 (PC der Fa. Bayer MaterialScience AG)
2. 50,0 Gew.-% Masterbatch (wie oben unter A) beschrieben)

Beispiel B)

Das Granulat des Materials für die Schicht mit der geometrische Struktur Makrolon 2600 wurde dem Fülltrichter des Coextruders zugeführt. Im Plastifiziersystem Zylinder/Schnecke der Extruder erfolgte das Aufschmelzen und Fördern des Materialien. Die Materialschmelze wurde dem Glättkalander zugeführt, dessen Walzen die in der untenstehenden Tabelle genannte Temperatur aufwiesen. Auf dem Glättkalander (bestehend aus drei Walzen) erfolgte die endgültige Formgebung und Abkühlung der Strahlungsauskopplungsschicht. In die Oberfläche der Walze 2 war die in Figur 4 abgebildete Struktur eingefräst. Zur Texturierung der entgegengesetzten Oberfläche wurde dabei eine Gummi-Walze eingesetzt. Die für die Strukturierung der Oberfläche verwendete Gummi-Walze ist in US- 4 368 240 der Fa. Nauta Roll Corporation offenbart. Anschließend wurde die Folie durch einen Abzug transportiert.

Tabelle:

| Verfahrensparameter | |
|---|---|
| Temperatur des Hauptextruders | etwa 275°C |
| Temperatur des Coextruders | etwa 260°C |
| Temperatur des Umlenkkopfes | etwa 285°C |
| Temperatur der Düse | etwa 300°C |

(fortgesetzt)

| Verfahrensparameter | |
|---|---|
| Drehzahl des Hauptextruders | 45 min$^{-1}$ |
| Temperatur der Gummiwalze 1 | 24°C |
| Temperatur der Walze 2 | 72°C |
| Temperatur der Walze 3 | 131°C |
| Abzugsgeschwindigkeit | 21,5 m/min |

Die Streueigenschaften der Strahlungsauskopplungsschicht bzw. der Teilschicht, die Streuzentren enthält, lassen sich zuverlässig und auf besonders einfache Weise mittels der Henyey-Greenstein-Phasenfunktion P

$$P(\cos\vartheta) = \frac{1-g^2}{4\pi\left(1+g^2-2g\cos\vartheta\right)^{\frac{3}{2}}}$$

beschreiben.

Hierbei ist $\vartheta$ der Zwischenwinkel zwischen einem auf die Strahlungsauskopplungsschicht einfallenden Strahl und diesem Strahl nach der Streuung. Erfolgt in der Strahlungsauskopplungsschicht eine Transmission so ist $\vartheta$ zwischen der (gedachten) Fortsetzung des einfallenden Strahls auf der Austrittsseite und dem austretenden Strahl gebildet.

Der Streu-Anisotropiefaktor g (g-Faktor) beschreibt die Streueigenschaften der Strahlungsauskopplungsschicht. Dieser g-Faktor liegt zwischen -1 und 1, wobei ein Wert von -1 spiegelartiger Rückstreuung, ein Wert von 0 isotroper Streuung und ein Wert von 1 keiner Änderung im Strahlverlauf entspricht. g-Faktoren im Bereich größer 0 geben die Vorwärtsstreuung an. Der g-Faktor ist experimentell zugänglich.

In einer bevorzugten Ausgestaltung ist die Strahlungsauskopplungsschicht 8 bzw. die Streubereiche enthaltende Teilschicht 81 derart ausgebildet, dass der g-Faktor 0,3 bis 0,9, bevorzugt 0,5 bis 0,7, beträgt. Hierdurch lässt sich die auskoppelbare Strahlungsleistung deutlich erhöhen.

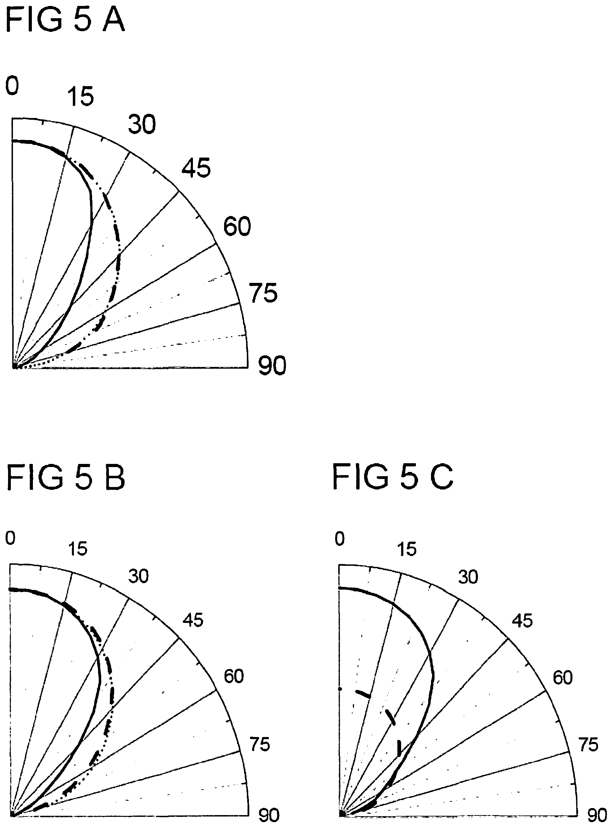

Figur 5A, 5B und 5C zeigen den Anteil ausgekoppelter Strahlungsleistung abhängig vom Beobachtungswinkel (0 - 90°) für eine OLED. Zusätzlich ist das Abstrahlungsprofil eines Lambertschen Strahlers gezeigt. Für die Messung wurde eine weißes Licht emittierende OLED eingesetzt. Die verwendete OLED weist eine aus zwei Teilschichten bestehenden Strahlungsauskopplungsschicht der Dicke 188 $\mu$m (Teilschicht mit Strukturelementen) und 300 $\mu$m (Teil-schicht mit Streupartikeln) auf. Die dem Substrat näher liegende Teilschicht enthält als Streupartikel 10 Gew.-% Techpolymer MBX 5 (der Fa. Sekisui) und als Matrixmaterial Makrolon 3108. Sämtliche Versuche wurden mit bei einer Stromdichte von 4,3 mA/cm$^2$ durchgeführt. Ein Beobachtungswinkel von 0° in Fig. 5 A-C entspricht dabei einem Beobachtungswinkel entlang der Flächennormalen bzw. des Normalenvektors (wie oben beschrieben).

Figur 5 A zeigt das normierte Abstrahlungsprofil für eine Anordnung mit einer Mikrostrukturierung in Form von Mikrolinsen mit voneinander beabstandet vorliegenden Teilschichten als durchgezogene Linie (die Beabstandung wird durch die Oberflächenrauheit der Teilschicht, die die geometrischen Strukturelemente enthält, realisiert). Als gestrichelte Linie ist das normierte Abstrahlungsprofil einer entsprechenden Anordnung, die keine Strahlungsauskopplungsschicht aufweist gezeigt. Die gepunktete Linie zeigt das Abstrahlungsprofil eines Lambertschen Strahlers. Eine OLED mit einer derart ausgebildeten Strahlungsauskopplungsschicht eignet sich insbesondere für Strahlungsquellen, die vom zu beleuchtenden Objekt verhältnismäßig weit entfernt angeordnet sind (z.B. Deckenleuchten in Räumen); die Intensität der ausgekoppelten Strahlung ist insbesondere bei Beobachtungswinkeln zwischen -30 und +30 Grad gegenüber der einer Anordnung ohne Strahlungsauskopplungsschicht erhöht.

Figur 5 B zeigt das normierte Abstrahlungsprofil für eine Anordnung mit einer Mikrostrukturierung wie in Fig. 4 abgebildet. Die einzelnen Strukturelemente haben dabei eine rotationssymmetrische Geometrie (Höhe der Struktur 70 bis 74 $\mu$m, Abstand der Maxima 103 $\mu$m) und es liegen voneinander beabstandete Teilschichten vor (die Beabstandung wird durch die Oberflächenrauheit der Teilschicht, die die geometrischen Strukturelemente enthält, realisiert) - dargestellt als durchgezogene Linie. Als gestrichelte Linie ist das normierte Abstrahlungsprofil einer entsprechenden Anordnung, die keine Strahlungsauskopplungsschicht aufweist gezeigt. Die gepunktete Linie zeigt das Abstrahlungsprofil eines Lambertschen Strahlers. Eine OLED mit einer derart ausgebildeten Strahlungsauskopplungsschicht eignet sich insbesondere für Strahlungsquellen, die die relativ nahe am zu bestrahlenden Objekt angeordnet sind (etwa task lights z.B. für die Arbeitsplatz- oder Esstischbeleuchtung); die Intensität der ausgekoppelten Strahlung ist nicht nur bei Beobachtungswinkeln zwischen -30 und +30 Grad sondern auch in Beobachtungswinkeln zwischen -30 und -45 Grad bzw.

zwischen +30 und +45 Grad gegenüber der einer Anordnung ohne Strahlungsauskopplungsschicht erhöht.
Figur 5 C zeigt das Abstrahlungsprofil aus Figur 5 B in nicht normierter Form.

Mittels der erfindungsgemäßen OLEDS kann die Effizienz gesteigert werden und auch die Leuchtdichte entlang der Flächennormalen deutlich erhöht werden kann. Die Lichtausbeute einer erfindungsgemäßen OLED beträgt im Regelfall mindestens 20 lm/W gleichzeitig beträgt die Leuchtdichte bei 0° im Regelfall mindestens 1400 cd/m$^2$: Unabhängig von der Leuchtdichte bei 0° beträgt die Lichtausbeute bevorzugt mindestens 22 lm/W; Unabhängig von der Lichtausbeute beträgt die Leuchtdichte bei 0° üblicherweise mindestens 1550 cd/m$^2$, bevorzugt mindestens 1650 cd/m$^2$ und besonders bevorzugt mindestens 1800 cd/m$^2$.

Die nachfolgenden Tabelle verdeutlicht Steigerung der Effizienz und die Erhöhung der Leuchtdichte entlang der Flächennormalen anhand konkreter Beispiele. Die Messungen wurden mittels einer Anordnung wie für Figur 5 A-C beschrieben durchgeführt:

| Partikel-Gehalt□ [Gew.-%] / Dicke$^◊$ [pm] | Geometrische Strukturelemente | Beabstandete Teilschichten | Lichtausbeute [lm/W] | Leuchtdichte bei 0° [cd/m$^2$] |
|---|---|---|---|---|
| 4 / 100 | MLA | ja | 20,7 | 1597 |
| 10 / 100 | MLA | ja | 23,0 | 1819 |
| 10 / 200 | MLA | ja | 22,3 | 1834 |
| 10 / 300 | MLA | ja | 22,5 | 1858 |
| keine Schicht | MLA | ja | 17,5 | 1457 |
| 2 / 300 | MLA | nein | | 1422 |
| keine Schicht | MLA | nein | | 1579 |
| 2 / 300 | Keine Schicht | nein | | 1207 |
| Keine Strahlungsauskopplungsschicht | | | 21,5 | 981 |
| * MLA = Mikrolinsen-Array □ als Streupartikel wurde Techpolymer MBX 5 (Fa. Sekisui) in Makrolon 3108 als Matrix verwendet ◊ Schichtdicke der die Streupartikel enthaltenden Teilschicht Sämtliche Versuche wurden bei einer Stromdichte von 4,3 mA/cm$^2$ durchgeführt. | | | | |

Der Tabelle ist zu entnehmen, dass durch eine Anordnung mit einer Mikrostrukturierung mit regelmäßig angeordneten geometrischen Strukturelementen (in Form eines Mikrolinsen-Arrays) eine deutlich erhöhte Leuchtdichte bei 0° resultiert. Eine zusätzliche Erhöhung kann durch Anordnungen mit beabstandeten Teilschichten realisiert werden. Ferner ist der Tabelle zu entnehmen, dass durch eine Erhöhung des Partikelgehalts sowohl die Leuchtdichte bei 0° als auch die Lichtausbeute deutlich ansteigt und bei einer Erhöhung der Schichtdicke der die Partikel enthaltenden Schicht eine zusätzliche Erhöhung der Leuchtdichte bei 0° resultiert.

Neben der erhöhten Auskopplung, insbesondere bei Betrachtungswinkeln von 0 bis 45 ° liegt ein weiterer Vorteil der erfindungsgemäßen Strahlungsauskopplungsschicht darin, dass Schwankungen im Farbort vermindert werden können. Der Farbort kann sich insbesondere mit dem Blickwinkel ändern. Derartige Farbortschwankungen sind bei vielen OLEDs intrinsisch vorhanden. Farbortschwankungen, das heißt Schwankungen in der x- und/oder y-Koordinate gemäß der CIE (Commission internationale de l'eclairage), können mittels der erfindungsgemäßen Strahlungsauskopplungsschicht reduziert werden (vergleiche Figur 6). Für die Schwankungen des Farborts $\Delta x$ und $\Delta y$ gilt bei den erfindungsgemäßen Vorrichtungen generell im Regelfall folgendes (bei Messungen für die Betrachtungswinkel von 0 bis 45 °): $\Delta x \leq 0,1$ und/oder $\Delta y \leq 0,05$. Häufig gilt sogar $\Delta x \leq 0,07$ und/oder $\Delta y \leq 0,025$ und vielfach auch $\Delta x \leq 0,04$ und/oder $\Delta y \leq 0,015$. Die Differenz $\Delta x$ und $\Delta y$ ist hierbei folgendermaßen definiert: $\Delta x = x_{max} - x_{min}$ und $\Delta y = y_{max} - y_{min}$, wobei $x_{max}$ und $y_{max}$ den maximalen für einen Betrachtungswinkel zwischen 0 und 45 ° gemessenen x- bzw. y-Wert darstellt und $x_{min}$ und $y_{min}$ den minimalen für einen Betrachtungswinkel zwischen 0 und 45 ° gemessenen x- bzw. y-Wert.

Figur 6 A zeigt die CIE-Koordinaten für Emissions- (bzw. Beobachtungs-)winkel von 0°- bis 70° (in 5°-Schritten gemessen). Die Messpunkte für eine Anordnung mit einer Mikrostrukturierung in Form von Mikrolinsen mit voneinander beabstandet vorliegenden Teilschichten sind als ausgefüllte Quadrate gekennzeichnet (die selbe Anordnung liegt auch Figur 5 A - durchgezogene Linie -zugrunde). Die Messpunkte für die selbe Anordnung mit einer Mikrostrukturierung in Form von Mikrolinsen mit voneinander beabstandet vorliegenden Teilschichten aber ohne eine Streupartikel enthaltende Teilschicht sind als nicht ausgefüllte Quadrate gekennzeichnet. Als Dreiecke sind die Messpunkte für eine entsprechenden Anordnung, die keine Strahlungsauskopplungsschicht aufweist, gezeigt (der 0°-Wert weist einen x-Wert von ca.

0,39 auf; die selbe Anordnung liegt auch Figur 5 A - gestrichelte Linie - zugrunde).

Figur 6 B zeigt die CIE-Koordinaten für Emissions- (bzw. Beobachtungs-)winkel von 0°- bis 75°. Die gemessenen Werte für eine Anordnung mit einer Mikrostrukturierung gemäß Figur 4 mit voneinander beabstandet vorliegenden Teilschichten sind als durchgezogene Linie gekennzeichnet (die selbe Anordnung liegt auch Figur 5 B - durchgezogene Linie -zugrunde). Die gemessenen Werte für eine entsprechenden Anordnung, die keine Strahlungsauskopplungsschicht aufweist, sind als gepunktete Linie gekennzeichnet (der 0°-Wert weist einen x-Wert von ca. 0,415 auf; die selbe Anordnung liegt auch Figur 5 B - gestrichelte Linie - zugrunde).

Figur 6 C zeigt zeigt die CIE-Koordinaten für Emissions- (bzw. Beobachtungs-)winkel von 0°- bis 70° (in 5°-Schritten gemessen). Die Messpunkte für eine Anordnung mit einer Mikrostrukturierung in Form von Mikrolinsen sind als ausgefüllte Quadrate gekennzeichnet. Im Unterschied zu Figur 6 A liegt hier eine Ausführungsform mit nicht voneinander beabstandeten Teilschichten vor. Die Messpunkte für die selbe Anordnung mit einer Mikrostrukturierung in Form von Mikrolinsen aber ohne eine Streupartikel enthaltende Teilschicht sind als nicht ausgefüllte Quadrate gekennzeichnet. Die Messpunkte für eine Anordnung ohne Mikrostrukturierung aber mit Streupartikeln sind als nicht ausgefüllte Kreise gekennzeichnet. Als Dreiecke sind die Messpunkte für eine entsprechenden Anordnung, die keine Strahlungsauskopplungsschicht und keine Streupartikel aufweist, gezeigt.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet.

**Patentansprüche**

1. Strahlungsemittierende Vorrichtung, umfassend

   - ein Substrat (4)
   - eine organische strahlungsemittierende Funktionsschicht (2), die eine Primärstrahlung emittiert, und
   - eine im Strahlengang der Primärstrahlung angeordnete Strahlungsauskopplungsschicht (8),

   wobei

   - die Strahlungsauskopplungsschicht eine Teilschicht (81) mit lichtstreuenden Regionen aufweist,
   - die Strahlungsauskopplungsschicht (8) auf der der strahlungsemittierenden Funktionsschicht abgewandten Seite eine Mikrostrukturierung (82) mit regelmäßig angeordneten geometrischen Strukturelementen (12) aufweist, sodass sich die Teilschicht mit den lichtstreuenden Regionen zwischen der Mikrostrukturierung und dem Substrat befindet,
   - die Strahlungsauskopplungsschicht die Teilschicht (81) mit den lichtstreuenden Regionen enthält, die eine Streuung der Primärstrahlung bewirken,
   - jede von einem Maximum der geometrischen Strukturelemente zu dessen Basis verlaufende ebene Kurve in ihrem der strahlungsemittierenden Schicht zugewandten untersten Drittel nur Krümmungen aufweist, die kleiner sind als jegliche Krümmung im entsprechenden obersten Drittel der ebenen Kurve,
   - Krümmungen im mittleren Drittel zwischen den Krümmungen im obersten und im untersten Drittel liegen,
   - als ebene Kurven solche Kurven gemeint sind, die auf einer Außenfläche des entsprechenden geometrischen Strukturelements verlaufen wie vom Pol zum Äquator verlaufende Längengrade eines Globus, und

   die Maxima zueinander benachbarter geometrischer Strukturelemente einen Abstand von 30 $\mu$m bis 500 $\mu$m aufweisen.

2. Strahlungsemittierende Vorrichtung nach dem vorhergehenden Anspruch, wobei die lichtstreuenden Regionen Partikel, Hohlpartikel und Gaseinschlüsse umfassen.

3. Strahlungsemittierende Vorrichtung nach einem der vorhergehenden Ansprüche, wobei die lichtstreuenden Regionen einen mittleren Durchmesser von 0,5 bis 100 $\mu$m, insbesondere von 2 bis 20 $\mu$m, besitzen.

4. Strahlungsemittierende Vorrichtung nach einem der vorhergehenden Ansprüche, wobei die geometrischen Strukturelemente ausgewählt werden aus Strukturelementen nach Art eines Segments eines Rotationsellipsoids sowie aus Mischungen von Strukturelementen nach Art eines Segments einer Kugel, Strukturelementen nach Art eines Segments eines Rotationsellipsoids, Strukturelementen nach Art einer Pyramide und Strukturelementen nach Art eines Kegels.

**5.** Strahlungsemittierende Vorrichtung nach einem der vorhergehenden Ansprüche, wobei die Regionen, die eine Streuung der Primärstrahlung bewirken, Streupartikel enthaltenen und die Streupartikel als Vollpartikel ausgebildet sind und einen Kern-Schale-Aufbau aufweisen.

**6.** Strahlungsemittierende Vorrichtung nach einem der vorhergehenden Ansprüche, wobei das geometrische Strukturelement eine Grundfläche besitzt, die ein Polygon ist.

**7.** Strahlungsemittierende Vorrichtung nach einem der vorhergehenden Ansprüche, wobei die Maxima zueinander benachbarter geometrischer Strukturelemente einen Abstand von 100 $\mu$m bis 250 $\mu$m besitzen.

**8.** Strahlungsemittierende Vorrichtung nach einem der vorhergehenden Ansprüche, die Strahlungsauskopplungsschicht neben Regionen, die eine Streuung der Primärstrahlung bewirken, eine Matrix aufweist, die ein für die Primärstrahlung transparentes Polymer, insbesondere ein Polycarbonat, umfasst.

**9.** Strahlungsemittierende Vorrichtung nach einem der vorhergehenden Ansprüche, wobei im Bereich der geometrischen Strukturelemente keine Teilbereiche, die eine Streuung der Primärstrahlung bewirken, vorgesehen sind.

**10.** Strahlungsemittierende Vorrichtung nach einem der vorhergehenden Ansprüche, wobei die Strahlungsauskopplungsschicht direkt auf der jeweils der strahlungsemittierenden Funktionsschicht abgewandten Seite eines Substrats, einer Barriereschicht oder einer transparenten Elektrode angeordnet ist.

**11.** Strahlungsemittierende Vorrichtung nach einem der vorhergehenden Ansprüche, wobei die Strahlungsauskopplungsschicht zumindest zwei voneinander beabstandete Teilschichten umfasst, wobei zwischen den Teilschichten ein Gas vorliegt und wobei ferner die einander zugewandten Grenzflächen der Teilschichten im Wesentlichen parallel zueinander verlaufen und im Wesentlichen parallel zur der strahlungsemittierenden Funktionsschicht zugewandten Fläche der Strahlungsauskopplungsschicht verlaufen.

**12.** Strahlungsemittierende Vorrichtung nach dem vorhergehenden Anspruch, wobei zwischen den beabstandeten Teilschichten eine Stützstruktur, insbesondere eine Stützstruktur aus einem transparenten Material, angeordnet ist.

**13.** Strahlungsemittierende Vorrichtung nach einem der vorhergehenden Ansprüche, die als OLED ausgebildet ist.

**14.** Strahlungsemittierende Vorrichtung nach einem der vorhergehenden Ansprüche, die zur Beleuchtung vorgesehen ist.

**15.** Verfahren zur Herstellung einer strahlungsemittierenden Vorrichtung nach einem der vorhergehenden Ansprüche, bei dem die Mikrostrukturierung mittels einer Metallwalze in eine Oberfläche der Strahlungsauskopplungsschicht eingeprägt wird.

**Claims**

**1.** Radiation-emitting device, comprising

- a substrate (4)
- an organic radiation-emitting functional layer (2), which emits a primary radiation, and
- a radiation decoupling layer (8) which is disposed in the beam path of the primary radiation,

wherein

- the radiation decoupling layer comprises a partial layer (81) having light-scattering regions,
- the radiation decoupling layer (8) comprises, on the side remote from the radiation-emitting functional layer, a microstructure (82) having regularly disposed geometric structural elements (12), so that the partial layer having the light-scattering regions is situated between the microstructure and the substrate,
- the radiation decoupling layer includes the partial layer (81) having the light-scattering regions, which effect a scattering of the primary radiation,
- each planar curve, which extends from a maximum of the geometric structural element to the base thereof, comprises in its lowermost third facing the radiation-emitting layer only curvatures which are smaller than any curvature in the corresponding uppermost third of the planar curve,

- curvatures in the central third are between the curvatures between the uppermost third and the lowermost third,
- planar curves refer to such curves which extend on the outer surface of the corresponding geometric structural element such as degrees of longitude of a globe which extend from the pole to the equator, and
- the maxima of mutually adjacent geometric structural elements comprise a spacing of 30 to 500 $\mu$m.

2. Radiation-emitting device as claimed in the preceding claim, wherein the light-scattering regions comprise particles, hollow particles and gas inclusions.

3. Radiation-emitting device as claimed in any one of the preceding claims, wherein the light-scattering regions comprise an average diameter of 0.5 to 100 $\mu$m, in particular 2 to 20 $\mu$m.

4. Radiation-emitting device as claimed in any one of the preceding claims, wherein the geometric structural elements are selected from structural elements in the manner of a segment of an ellipsoid of revolution as well as from mixtures of structural elements in the manner of a segment of a sphere, structural elements in the manner of a segment of an ellipsoid of revolution, structural elements in the manner of a pyramid and structural elements in the manner of a cone.

5. Radiation-emitting device as claimed in any one of the preceding claims, wherein the regions, which effect a scattering of the primary radiation, comprises scattering particles, and the scattering particles a formed as solid particles and have a core-shell morphology.

6. Radiation-emitting device as claimed in any one of the preceding claims, wherein the geometric structural element comprises a base surface which is a polygon.

7. Radiation-emitting device as claimed in any one of the preceding claims, wherein the maxima of mutually adjacent geometric structural elements comprise a spacing of 100 to 250 $\mu$m.

8. Radiation-emitting device as claimed in any one of the preceding claims, wherein in addition to regions which effect scattering of the primary radiation, the radiation decoupling layer comprises a matrix which comprises a polymer which is transparent to the primary radiation, in particular a polycarbonate.

9. Radiation-emitting device as claimed in any one of the preceding claims, wherein in the region of the geometric structural elements there are no partial regions which effect scattering of the primary radiation.

10. Radiation-emitting device as claimed in any one of the preceding claims, wherein the radiation decoupling layer is disposed directly on that side of a substrate, of a barrier layer or of a transparent electrode, which in each case is remote from the radiation-emitting functional layer.

11. Radiation-emitting device as claimed in any one of the preceding claims, wherein the radiation decoupling layer comprises at least two mutually spaced-apart partial layers, wherein a gas is present between the partial layers and wherein furthermore the mutually facing boundary surfaces of the partial layers extend substantially in parallel with one another and extend substantially in parallel with the surface of the radiation decoupling layer facing the radiation-emitting functional layer.

12. Radiation-emitting device as claimed in the preceding claim, wherein a support structure, in particular a support structure made of a transparent material, is disposed between the spaced-apart partial layers.

13. Radiation-emitting device as claimed in any one of the preceding claims, which is embodied as an OLED.

14. Radiation-emitting device as claimed in any one of the preceding claims, which is provided for lighting purposes.

15. Method for manufacturing a radiation-emitting device as claimed in any one of the preceding claims, wherein the microstructure is embossed into a surface of the radiation decoupling layer by means of a metal roller.

**Revendications**

1. Dispositif émetteur de rayonnement, comprenant

   - un substrat (4)
   - une couche fonctionnelle organique (2) émettrice de rayonnement qui émet un rayonnement primaire, et
   - une couche de découplage de rayonnement (8) disposée sur le chemin optique du rayonnement primaire,

   dans lequel

   - la couche de découplage de rayonnement contient une couche partielle (81) comportant des zones de dispersion de lumière,
   - la couche de découplage de rayonnement comporte, sur la face détournée de la couche fonctionnelle émettrice de rayonnement, une microstructure (82) comportant des éléments structurels géométriques (12) régulièrement disposés, de manière que la couche partielle comportant les zones de dispersion de lumière est disposée entre la microstructuration et le substrat,
   - la couche de découplage de rayonnement contient la couche partielle (81) comportant les zones de dispersion de lumière induisant une dispersion du rayonnement primaire,
   - chaque courbe plane s'étendant d'un maximum des éléments structurels géométriques vers sa base ne présente dans son tiers inférieur faisant face à la couche émettrice de rayonnement que des courbures plus petites que toute courbure du tiers supérieur correspondant de la courbe plane,
   - les courbures du tiers central rangent entre les courbures des tiers supérieur et inférieur,
   - par courbes planes, on entend les courbes qui s'étendent sur une surface extérieure de l'élément structurel géométrique correspondant, tel que les longitudes d'un globe s'étendant du pôle à l'équation, et
   - les maxima d'éléments structurels géométriques adjacents présentent un espacement de 30 à 500 $\mu$m.

2. Dispositif émetteur de rayonnement selon la revendication précédente, dans lequel les zones de dispersion de lumière comportent des particules, des particules creuses et des inclusions de gaz.

3. Dispositif émetteur de rayonnement selon l'une des revendications précédentes, dans lequel les zones de dispersion de lumière présentent un diamètre moyen de 0,5 à 100 $\mu$m, en particulier de 2 à 20 $\mu$m.

4. Dispositif émetteur de rayonnement selon l'une des revendications précédentes, dans lequel les éléments structurels géométriques sont choisis parmi des éléments structurels à la manière d'un segment d'ellipsoïde de rotation ainsi que parmi des mélanges d'éléments structurels à la manière d'un segment d'une sphère, d'éléments structurels à la manière d'un segment d'ellipsoïde de rotation, d'éléments structurels à la manière d'une pyramide et d'éléments structurels à la manière d'un cône.

5. Dispositif émetteur de rayonnement selon l'une des revendications précédentes, dans lequel les zones induisant une dispersion du rayonnement primaire contiennent des particules vagabondes, les particules vagabondes étant conçues sous forme de particules pleines présentant une structure noyau/enveloppe.

6. Dispositif émetteur de rayonnement selon l'une des revendications précédentes, dans lequel l'élément structurel géométrique présente une superficie de base qui est un polygone.

7. Dispositif émetteur de rayonnement selon l'une des revendications précédentes, dans lequel l'espacement des maxima d'éléments structurels géométriques adjacents est de 100 à 250 $\mu$m.

8. Dispositif émetteur de rayonnement selon l'une des revendications précédentes, dans lequel la couche de découplage de rayonnement, en plus de zones induisant une dispersion du rayonnement primaire, comprend une matrice comportant un polymère transparent au rayonnement primaire, en particulier un polycarbonate.

9. Dispositif émetteur de rayonnement selon l'une des revendications précédentes, dans lequel au droit des éléments structurels géométriques, aucune zone partielle induisant la dispersion du rayonnement primaire n'est prévue.

10. Dispositif émetteur de rayonnement selon l'une des revendications précédentes, dans lequel la couche de découplage de rayonnement est disposée directement sur la face d'un substrat respectivement détournée de la couche fonctionnelle émettrice de rayonnement, une couche barrière ou une électrode transparente.

**11.** Dispositif émetteur de rayonnement selon l'une des revendications précédentes, dans lequel la couche de découplage de rayonnement comprend au moins deux couches partielles espacées l'une de l'autre, un gaz étant présent entre les couches partielles, les interfaces des couches partielles en regard l'une de l'autre s'étendant sensiblement parallèlement l'une à l'autre et sensiblement parallèlement à la surface de la couche de découplage de rayonnement en regard de la couche fonctionnelle émettrice de rayonnement.

**12.** Dispositif émetteur de rayonnement selon la revendication précédente, dans lequel une structure de support, en particulier une structure de support en un matériau transparent, est agencée entre les couches partielles espacées.

**13.** Dispositif émetteur de rayonnement selon l'une des revendications précédentes conçu en tant qu'OLED.

**14.** Dispositif émetteur de rayonnement selon l'une des revendications précédentes prévu pour servir d'éclairage.

**15.** Procédé de fabrication d'un dispositif émetteur de rayonnement selon l'une des revendications précédentes, dans lequel la microstructuration est imprimée dans une surface de la couche de découplage de rayonnement au moyen d'un rouleau métallique.

FIG 1

## FIG 2

## FIG 3

## Fig. 4

138,3 µm

4 µm

12

100 µm

## Fig. 4 A

22    21    23

25

26

28

## FIG 5 A

## FIG 5 B

## FIG 5 C

## FIG 6 A

## FIG 6 B

# FIG 6 C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0237580 A1
- JP 2003109747 A
- JP 2006030872 A
- US 20050057176 A1
- WO 2009081750 A1
- WO 2006134536 A2
- US 20060290272 A
- US 20070126148 A
- US 20070126145 A
- EP 0500496 A
- EP 0517044 A
- US 2999835 A
- US 3148172 A
- US 2991273 A
- US 3271367 A
- US 4982014 A
- US 2999846 A
- DE 1570703
- DE 2063050
- DE 2036052
- DE 2211956
- DE 3832396
- FR 1561518
- WO 0105866 A
- WO 0105867 A
- US 3494885 A
- US 4386186 A
- US 4661580 A
- US 4680371 A
- US 4680372 A
- EP 26120 A
- EP 26121 A
- EP 26684 A
- EP 28030 A
- EP 39845 A
- EP 91602 A
- EP 97970 A
- EP 79075 A
- EP 146887 A
- EP 156103 A
- EP 234913 A
- EP 240301 A
- DE 1495626 A
- DE 2232977 A
- US 3419634 A
- DE OS3334782 A
- WO 200026275 A
- DE OS2940024 A
- DE OS3007934 A
- US 3189662 A
- US 3821325 A
- US 3832419 A
- EP 634445 A
- US 4226752 A
- EP 0269324 A
- US 3793402 A
- US 3808180 A
- EP 0110221 A
- EP 0110238 A
- US 4368240 A

**In der Beschreibung aufgeführte Nicht-Patentliteratur**

- **HORST GREINER.** *Japanese Journal of Applied Physics,* 2007, vol. 46 (7A), 4125-4137
- **H. SCHNELL.** Chemistry and Physics of Polycarbonates, Polymer Reviews. Interscience Publishers, 1964, vol. 9, 33 ff
- Condensation Polymers by Interfacial and Solution Methods. **PAUL W. MORGAN.** Polymer Reviews. Interscience Publishers, 1965, vol. 10, 325
- Polycarbonate, Polyacetale, Polyester, Celluloseester. **DRES. U. GRIGO ; K. KIRCHER ; P. R-MÜLLER.** Becker/Braun, Kunststoff-Handbuch. Carl Hanser Verlag München, 1992, vol. 3/1, 118-145
- **H. SCHNELL.** Chemistry and Physics of Polycarbonates. Interscience Publishers, 1964, 28, , 102
- **D.G. LEGRAND ; J.T. BENDLER.** Handbook of Polycarbonate Science and Technology. Marcel Dekker, 2000, 72
- **H. SCHNELL.** Chemistry and Physics of Polycarbonates Polymer Rev. Interscience Publishers, 1964, vol. IX, 27